# EUROPEAN PATENT SPECIFICATION

(11) **EP 2 096 690 B1**
(45) Date of publication and mention of the grant of the patent: **24.04.2013**
(21) Application number: 09002857.2
(22) Date of filing: 27.02.2009
(51) Int. Cl.: H01L 51/50, H01L 51/54

(54) **Organic electroluminescence device**
Organische Elektrolumineszenzvorrichtung
Dispositif électroluminescent organique

(30) Priority: 28.02.2008 JP 2008048509; 07.01.2009 JP 2009002059
(43) Date of publication of application: 02.09.2009
(73) Proprietor: UDC Ireland Limited, Dublin 4 (IE)
(72) Inventor: Takeda, Akira, Ashigarakami-gun Kanagawa (JP); Tobise, Manabu, Ashigarakami-gun Kanagawa (JP); Satou, Tasuku, Ashigarakami-gun Kanagawa (JP)
(74) Representative: HOFFMANN EITLE

(56) References cited:
- JP-A- 2006 120 811
- US-A1- 2006 159 951
- ABIKO N ET AL: "CARRIER INJECTION CHARACTERISTICS OF METAL/TRIS-(8-HYDROXYQUINOLINE) ALUMINUM INTERFACE WITH LONG CHAIN ALKANE INSERTION LAYER", JAPANESE JOURNAL OF APPLIED PHYSICS, JAPAN SOCIETY OF APPLIED PHYSICS, JP, vol. 45, no. 1B, 1 January 2006 (2006-01-01), pages 442-446, XP001245536, ISSN: 0021-4922, DOI: DOI:10.1143/JJAP.45.442

## Description

### BACKGROUND OF THE INVENTION

### 1. Field of the Invention

The present invention relates to an organic electroluminescence device (hereinafter also referred to as "an organic EL device", "luminescence device" or "device") capable of converting electric energy to light and emitting light. Specifically the invention relates to an organic electroluminescence device excellent in driving voltage and EL external light emission efficiency.

### 2. Description of the Related Art

In recent years, studies and developments in connection with various displays using organic light-emitting materials (organic luminescence devices) have been actively advanced. Above all, organic EL devices are attracting public attention as promising displays for capable of emitting light of high luminance with low voltage.

Further, in recent years, increment in efficiency of the devices has been advanced by the use of phosphorescent materials. As the phosphorescent materials, iridium complexes and platinum complexes are described in U.S. Patent 6,303,238, WO 00/57,676 and WO 00/70,655. However, devices that satisfy driving voltage, efficiency and durability are not yet obtained even with these techniques.

For the improvement of light emitting efficiency, an organic luminescence device having a light-emitting layer consisting of only a material comprising a light-emitting material and a single bond alone is described in JP-A-2006-120811 (The term "JP-A" as used herein refers to an "unexamined published Japanese patent application".), but a compound consisting of a single bond alone has no π electron bearing charge transporting, therefore, it is presumed that such a compound is disadvantageous in the point of driving voltage as compared with the case of using aromatic compounds generally widely used as charge transporting materials.

It is described in JP-A-2007-299825 to use a monocyclic saturated hydrocarbon compound with a phosphorescent material, but there is no description concerning lowering of driving voltage.

Further, it is described in Japanese Journal of Applied Physics, Vol. 45, No. 1B, Item 442-446 (2006) that in a device in which tetratetracotane alone, which is a hydrocarbon compound comprising only single bonds, is used in the organic layer in contact with a metal electrode, applied voltage lowers in the extremely thin organic layer of several nanometers, but in the case of an organic layer having a thickness of 10 nanometers, resistance is large and electric current hardly flows.

### SUMMARY OF THE INVENTION

An object of the invention is to provide a luminescence device low in driving voltage and excellent in EL external quantum efficiency.

The above object has been achieved by the following means.
[1] An organic electroluminescence device comprising:
   a pair of electrodes; and
   at least one organic layer including a light-emitting layer being provided between the pair of electrodes,
   wherein
   at least any one of the at least one organic layer contains both at least one hydrocarbon compound having an alkyl structure and a charge transporting material, and
   the hydrocarbon compound having an alkyl structure is a saturated straight chain hydrocarbon compound not containing a double bond and containing a -CH₂CH₂-structure.
[2] The organic electroluminescence device as described in [1],
   wherein
   the hydrocarbon compound having an alkyl structure is solid at room temperature.
[3] The organic electroluminescence device as described in [1] or [2],
   wherein
   the hydrocarbon compound having an alkyl structure is contained in the organic layer in an amount of from 0.1 to 25 wt.%.
[4] The organic electroluminescence device as described in any of [1] to [3],
   wherein
   the light-emitting layer contains the hydrocarbon compound having an alkyl structure.
[5] The organic electroluminescence device as described in any of [1] to [4],
   wherein
   the light-emitting layer contains at least one phosphorescent material.
[6] The organic electroluminescence device as described in any of [1] to [5],
   wherein
   the charge transporting material is a hole-transporting material.
[7] The organic electroluminescence device as described in any of [1] to [6],
   wherein
   the light-emitting layer contains a metal complex phosphorescent material.
[8] The organic electroluminescence device as described in any of [1] to [7],
   wherein
   the light-emitting layer contains an iridium complex material or a platinum complex material.
[9] The organic electroluminescence device as described in any of [1] to [8],
wherein
the light-emitting layer contains a platinum complex material having a tetradentate ligand.

### DETAILED DESCRIPTION OF THE INVENTION

The organic electroluminescence device in the invention (hereinafter sometimes referred to as "the device in the invention") is an organic electroluminescence device comprising a pair of electrodes and at least one organic layer (which may be a layer comprising an organic compound alone or may be a layer containing an organic compound and an inorganic compound) including a light-emitting layer between the pair of electrodes, and at least any one of the at least one organic layer contains both at least one hydrocarbon compound having an alkyl structure and a charge transporting material.

In general, it is known that in charge (electron/hole) injection at organic film interface of a lamination type organic electronic device, when the difference in ionization potentials (Ip) each other and electron affinities (Ea) each other of contiguous two materials is small, barrier of charge injection is small, and driving voltage of an organic electroluminescence device can be reduced, but energy level originating in interaction among the molecules of the materials performs important duties besides Ip and Ea of the materials. In addition, as to charge transfer in an organic layer, by appropriately controlling interaction among the molecules of the materials, the electric charge mobility can be made great and driving voltage of the device can be lowered. By properly using the hydrocarbon compound having an alkyl structure of the invention with a charge transporting material, there is a possibility that interaction among the molecules of the materials can be controlled and, as a consequence, it becomes possible to lower driving voltage. Further, the change in the state of interaction among the molecules of the materials (for example, the state of association) at the time of driving of the device brings about change in the characteristics of the device, and may cause reduction of luminance (that is, the duration of life of the device), but there is a possibility that this problem can be avoided by suitably using the hydrocarbon compound having an alkyl structure of the invention with a charge transporting material to form a stable state of interaction in advance. The hydrocarbon compound having an alkyl structure used in the organic electroluminescence device in the invention is excellent in chemical stability, almost free from change of properties such as decomposition of the materials during driving of the device, and reductions of efficiency of the organic electroluminescence device and the duration of life of the device due to decomposition of the material can be prevented.

The hydrocarbon compound having an alkyl structure of the invention is a compound consisting of a carbon atom and a hydrogen atom (including a deuterium atom) alone, namely

saturated straight chain hydrocarbon compound not containing a double bond in the molecule and containing at least a structure represented by "-CH₂CH₂-".

As the straight chain structure, for example, (CH₂)ₙ and (CH₂)ₙCH₃ (n is an integer of 2 to 100) are exemplified, Of these structures, (CH₂)ₙ and (CH₂)ₙCH₃ (n is an integer of 2 to 100) of the straight chain structure are preferred, more preferably those in which n is an integer of 2 to 50, and especially preferably n is an integer of 2 to 30.

The straight chain saturated hydrocarbon compound means, for example, straight chain alkane such as represented by exemplified compound 1-1 to 1-10 described later in the specific examples.

Since the organic electroluminescence device in the invention is manufactured by a vacuum deposition process or a solution coating process, the molecular weight of the hydrocarbon compound having an alkyl structure of the invention is preferably 2,000 or less from the points of deposition suitability and solubility, more preferably 1,200 or less, and especially preferably 1,000 or less. Further, in the point of deposition suitability, vapor pressure becomes small when the molecular weight is too small and transition from a vapor phase to a solid phase does not occur and formation of an organic layer is difficult, so that the molecular weight is preferably 250 or more, more preferably 350 or more, and especially preferably 400 or more.

It is preferred in the invention for the hydrocarbon compound having an alkyl structure to be in a solid state at room temperature (25°C), more preferably in a solid state in the range of room temperature (25°C) to 40°C, and especially preferably in a solid state in the range of room temperature (25°C) to 60°C.

When a hydrocarbon compound having an alkyl structure that does not form a solid at room temperature (25°C) is used, a solid phase can be formed by the combination with other materials.

As other materials, they are more preferably solids at room temperature (25°C), and the later-described charge transporting materials can be exemplified in the invention. Specifically indole derivatives, carbazole derivatives and aromatic tertiary amine compounds of a molecular weight of 250 or more are preferred.

In the invention, the hydrocarbon compound having an alkyl structure of the invention is not restricted in uses, and may be contained in any layer of the organic layers. As the layers to which the hydrocarbon compound having an alkyl structure of the invention is introduced, it is preferred that the compound is introduced to any one layer or two or more layers of the later-described light-emitting layer, hole-injecting layer, hole-transporting layer, electron-transporting layer, electron-injecting layer, exciton-blocking layer, and charge-blocking layer, it is more preferred to be introduced to any one layer or two or more layers of light-emitting layer, hole-injecting layer, hole-transporting layer, electron-transporting layer, and electron-injecting layer, and it is especially preferred to be introduced to any one layer or two or more layers of light-emitting layer, hole-injecting layer, and hole-transporting layer.

The charge-transporting material to be used with the hydrocarbon compound having an alkyl structure of the invention is an electron-transporting material or a hole-transporting material, and preferably a hole-transporting material. The electron-transporting material here means the later-described electron-transporting host material, electron-transporting material and electron-injecting material, and the hole-transporting material means the later-described hole-transporting host material, hole-transporting material and hole-injecting material.

When the hydrocarbon compound having an alkyl structure of the invention is contained in a light-emitting layer, the compound is used together with the later-described light emitting dopant (also referred to as "light-emitting material") and charge transporting host material.

The host material to be used with the hydrocarbon compound having an alkyl structure of the invention may be a hole-transporting host material or an electron-transporting host material, but a hole-transporting host material is preferably used.

When the hydrocarbon compound having an alkyl structure of the invention is used in an organic layer, it is necessary for the content of the hydrocarbon compound having an alkyl structure to be restricted so as not to restrain the charge transporting property of the charge transporting material. The hydrocarbon compound having an alkyl structure of the invention is preferably contained in an amount of 0.1 to 70 wt.%, more preferably 0.1 to 30 wt.%, and especially preferably contained in an amount of 0.1 to 25 wt.%.

When the hydrocarbon compound having an alkyl structure of the invention is used in a plurality of organic layers, it is preferred to use in the above range in each layer.

The hydrocarbon compound having an alkyl structure of the invention may be contained by one kind alone in any organic layer, or a plurality of hydrocarbon compounds having an alkyl structure may be contained as a combination in an arbitrary proportion.

The specific examples of the hydrocarbon compounds having an alkyl structure are shown below, but the invention is not restricted to these compounds.

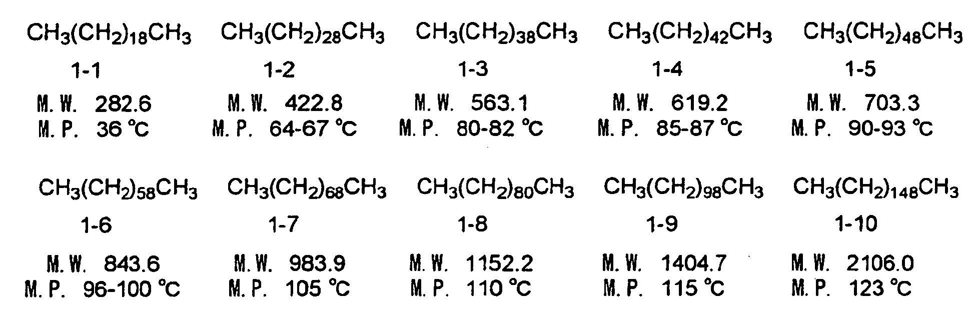

### Organic Electroluminescence Device:

The device of the invention will be described in detail below.

The organic electroluminescence device of the invention is an organic electroluminescence device comprising a pair of electrodes and at least one organic layer including a light-emitting layer between the pair of electrodes, and at least any one organic layer contains both at least one hydrocarbon compound having an alkyl structure and a charge transporting material.

That is, the luminescence device of the invention has a cathode and an anode on a substrate, and an organic layer including a light-emitting layer between both electrodes. It is preferred from the nature of the luminescence device that at least either one electrode of the cathode and anode is transparent.

The substrates, cathodes and anodes for use in the organic electroluminescence device are disclosed in detail in, for example, JP-A-2007-324309, paragraphs [0085] to [0104] and JP-A-2007-266458, paragraphs [0064] to [0084], and these items are applicable to the invention.

### Organic Layer:

The organic layer in the invention will be described.

The organic EL device in the invention has at least one organic layer including a light-emitting layer. As organic layers other than the light-emitting layer, a hole-transporting layer, an electron-transporting layer, a charge-blocking layer, a hole-injecting layer and an electron-injecting layer are exemplified as described above.

As the mode of lamination of organic layers in the invention, an embodiment of lamination of a hole-transporting layer, a light-emitting layer, and an electron-transporting layer from the anode side is preferred. Further, a hole-injecting layer is provided between a hole-transporting layer and an anode, and/or an electron-transporting intermediate layer is provided between a light-emitting layer and an electron-transporting layer. Further, a hole-transporting intermediate layer between a light-emitting layer and a hole-transporting layer, and an electron-injecting layer between a cathode and an electron-transporting layer may be provided respectively.

Incidentally, each layer may be divided to a plurality of secondary layers.

In the organic EL device in the invention, each layer constituting the organic layers can be preferably formed by any of dry film-forming methods such as a vacuum deposition method and a sputtering method, a wet coating method, a transfer method, a printing method, and an ink jet method.

### Light-Emitting Layer:

The light-emitting layer is a layer having functions to receive, at the time of electric field application, holes from the anode, hole injecting layer or hole transporting layer, and to receive electrons from the cathode, electron-injecting layer or electron-transporting layer, and offer the field of recombination of holes and electrons to emit light.

It is preferred the light-emitting layer in the invention is constituted as a mixed layer of a host material and a light-emitting dopant.

The details of the light-emitting layer will be described in the item of host materials later.

In the invention, it is preferred for the hydrocarbon compound having an alkyl structure to be contained in the light-emitting layer. By the use of the hydrocarbon compound having an alkyl structure, preferably the hydrocarbon compound having an alkyl structure and an adamantane structure, a light-emitting dopant (a light-emitting material), and a host material together in the light-emitting layer, charge injection to the light-emitting layer and charge transfer in the light-emitting layer are improved, and the effect of reduction of driving voltage is obtained, and so preferred.

As the light-emitting dopants in the invention, phosphorescent materials and fluorescent materials can be used.

For the purpose of improving color purity and expanding light emission wavelength region, the light-emitting layer in the invention can contain two or more kinds of light-emitting dopants, and it is preferred to contain at least one kind of a phosphorescent material.

### Fluorescent light-emittin dopants :

The examples of the fluorescent light-emitting dopants generally include various metal complexes represented by metal complexes of benzoxazole, benzimidazole, benzothiazole, styrylbenzene, polyphenyl, diphenylbutadiene, tetraphenylbutadiene, naphthalimide, coumarin, pyran, perinone, oxadiazole, aldazine, pyraridine, cyclopentadiene, bisstyrylanthracene, quinacridone, pyrrolopyridine, thiadiazolopyridine, cyclopentadiene, styrylamine, aromatic dimethylidyne compounds, condensed polycyclic aromatic compounds (anthracene, phenanthroline, pyrene, perylene, rubrene, pentacene, etc.), and 8-quinolinol, pyrromethene complexes, and rare earth complexes, polymer compounds, e.g., polythiophene, polyphenylene, polyphenylenevinylene, etc., organic silanes, and the derivatives thereof.

### Phosphorescent light-emitting dopants:

As the phosphorescent light-emitting dopants, complexes containing a transition metal atom or a lanthanoid atom can be generally exemplified.

For example, the transition metal atom is not especially restricted, but preferably ruthenium, rhodium, palladium, tungsten, rhenium, osmium, iridium, gold, silver, copper and platinum are exemplified, more preferably rhenium, iridium and platinum, and still more preferably iridium and platinum are exemplified.

As the lanthanoid atoms, e.g., lanthanum, cerium, praseodymium, neodymium, samarium, europium, gadolinium, terbium, dysprosium, holmium, erbium, thulium, ytterbium and lutetium are exemplified, and cerium, neodymium, europium and gadolinium are preferred of these lanthanoid atoms.

As the examples of ligands of complexes, the ligands described, for example, in G Wilkinson et al., Comprehensive Coordination Chemistry, Pergamon Press (1987), H. Yersin, Photochemistry and Photophysics of Coordination Compounds, Springer-Verlag (1987), and Akio Yamamoto, Yuki Kinzoku Kagaku -Kiso to Oyo-(Organic Metal Chemistry -Elements and Applications), Shokabo Publishing Co. (1982) are exemplified.

As the specific examples of ligands, halogen ligands (preferably a chlorine ligand), aromatic carbocyclic ligands (preferably having from 5 to 30 carbon atoms, more preferably from 6 to 30 carbon atoms, still more preferably from 6 to 20 carbon atoms, and especially preferably from 6 to 12 carbon atoms, e.g., a cyclopentadienyl anion, a benzene anion, a naphthyl anion, etc.), nitrogen-containing heterocyclic ligands (preferably having from 5 to 30 carbon atoms, more preferably from 6 to 30 carbon atoms, still more preferably from 6 to 20 carbon atoms, and especially preferably from 6 to 12 carbon atoms, e.g., phenylpyridine, benzoquinoline, quinolinol, bipyridyl, phenanthroline, etc.), diketone ligands (e.g., acetylacetone, etc.), carboxylic acid ligands (preferably having from 2 to 30 carbon atoms, more preferably from 2 to 20 carbon atoms, and still more preferably from 2 to 16 carbon atoms, e.g., an acetic acid ligand, etc.), alcoholate ligands (preferably having from 1 to 30 carbon atoms, more preferably from 1 to 20 carbon atoms, and still more preferably from 6 to 20 carbon atoms, e.g., a phenolate ligand, etc.), silyloxy ligands (preferably having from 3 to 40 carbon atoms, more preferably from 3 to 30 carbon atoms, and still more preferably from 3 to 20 carbon atoms, e.g., a trimethylsilyloxy ligand, a dimethyl-tert-butysilyloxy ligand, a triphenylsilyloxy ligand, etc.), carbon monoxide ligands, isonitrile ligands, cyano ligands, phosphorus ligands (preferably having from 3 to 40 carbon atoms, more preferably from 3 to 30 carbon atoms, still more preferably from 3 to 20 carbon atoms, and especially preferably from 6 to 20 carbon atoms, e.g., a triphenylphosphine ligand, etc.), thiolate ligands (preferably from 1 to 30 carbon atoms, more preferably from 1 to 20 carbon atoms, and still more preferably from 6 to 20 carbon atoms, e.g., a phenylthiolate ligand, etc.), phosphine oxide ligands (preferably having from 3 to 30 carbon atoms, more preferably from 8 to 30 carbon atoms, and still more preferably from 18 to 30 carbon atoms, e.g., a triphenylphosphine oxide ligand, etc.) are preferably exemplified, and more preferably nitrogen-containing heterocyclic ligands are exemplified.

These complexes may have one transition metal atom in a compound, or they may be what are called polynuclear complexes having two or more transition metal atoms. They may contain dissimilar metal atoms at the same time.

Of these, as the specific examples of light emitting dopants, phosphorescent compounds as disclosed in U.S. Patents 6,303,238B1, 6,097,147, WO 00/57,676, WO 00/70,655, WO 01/08,230, WO 01/39,234A2, WO 01/41,512A1, WO 02/02,714A2, WO 02/15,645A1, WO 02/44,189A1, WO 05/19,373A2, JP-A-2001-247859, JP-A-2002-302671, JP-A-2002-117978, JP-A-2003-133074, JP-A-2002-235076, JP-A-2003-123982, JP-A-2002-170684, EP 1,211,257, JP-A-2002-226495, JP-A-2002-234894, JP-A-2001-247859, JP-A-2001-298470, JP-A-2002-173674, JP-A-2002-203678, JP-A-2002-203679, JP-A-2004-357791, JP-A-2006-256999, JP-A-2007-19462, JP-A-2007-84635, and JP-A-2007-96259 are exemplified. As more preferred light emitting dopants, Ir complexes, Pt complexes, Cu complexes, Re complexes, W complexes, Rh complexes, Ru complexes, Pd complexes, Os complexes, Eu complexes, Tb complexes, Gd complexes, Dy complexes, and Ce complexes are exemplified. Ir complexes, Pt complexes and Re complexes are very preferred, and Ir complexes, Pt complexes and Re complexes containing at least one coordination system of a metal-carbon bond, a metal-nitrogen bond, a metal-oxygen bond and a metal-sulfur bond are preferred. Further, in the light of light emission efficiency, driving durability and chromaticity, Ir complexes, Pt complexes and Re complexes containing tridentate or higher multidentate ligand are particularly preferred, and Ir complexes and Pt complexes are most preferred. Pt complexes having a tetradentate ligand are preferred above all.

Light emitting dopants are not particularly restricted, but it is preferred to use phosphorescent materials, and especially preferred to use metal complex phosphorescent materials in the light-emitting layer. As the metal complex phosphorescent materials, it is more preferred to use iridium complex phosphorescent materials or platinum complex phosphorescent materials, and it is especially preferred to use platinum complex phosphorescent materials having a tetradentate ligand, but other phosphorescent materials may be used in combination.

As the complex phosphorescent materials, the compounds described in Coordination Chemistry Reviews, 250, 2093-2126 (2006) can be exemplified.

As the iridium complex phosphorescent materials, the compounds disclosed in WO 00/70,655, WO 01/41,512, WO 02/5,645, JP-A-2002-117978, WO 04/085,450, WO 06/121,811, WO 05/019,373, and WO 05/113,704 are exemplified.

As the platinum complex phosphorescent materials, the compounds disclosed in WO 00/57,676 are exemplified.

As the platinum complex (phosphorescent) materials having a tetradentate ligand, the compounds disclosed in U.S. Patent 6,653,654, WO 04/099,339, WO 04/108,857, JP-A-2005-310733, JP-A-2005-317516, JP-A-2006-261623, JP-A-2006-93542, JP-A-2006-256999, WO 06/098,505, JP-A-2007-19462, JP-A-2007-96255, JP-A-2007-96259, WO 05/042,444, JP-A-2006-232784, U.S. Patent 0,134,461, and WO 05/042,550 are preferably exemplified.

As the platinum complex (phosphorescent) materials having a tetradentate ligand, those containing 2-arylpyridine derivative, 2-(1-pyrazolyl)pyridine derivative, or 1-arylpyrazole derivative as the partial structure of a ligand are preferred, those containing 2-arylpyridine derivative or 2-(1-pyrazolyl)pyridine derivative as the partial structure of a ligand are more preferred, and those containing 2-(1-pyrazolyl)pyridine derivative as the partial structure of a ligand are especially preferred.

The partial structures of the ligands (for example, a 2-arylpyridine derivative, a 2-(1-pyrazolyl)pyridine derivative, and a 1-arylpyrazole derivative) are linked at a proper site to constitute tetradentate ligands.

When a 2-arylpyridine derivative is contained as the partial structures of a ligand, the position of linkage is preferably the 6-position of the pyridine ring, or the meta-position to the pyridine ring of the aryl group, more preferably the 6-position of the pyridine ring to each other, or the meta-position to the pyridine ring of the aryl group to each other, and especially preferably the 6-position of the pyridine ring to each other.

When a 2-(1-pyrazolyl)pyridine derivative is contained as the partial structures of a ligand, the position of linkage is preferably the 6-position of the pyridine ring, or the 4-position of the 1-pyrazolyl group, more preferably the 6-position of the pyridine ring to each other, or the 4-position of the 1-pyrazolyl group to each other, and especially preferably the 6-position of the pyridine ring to each other.

When a 1-arylpyrazole derivative is contained as the partial structures of a ligand, the position of linkage is preferably the 3-position of the pyrazole ring, or the meta-position to the pyrazole ring of the aryl group, more preferably the 3-position of the pyrazole ring to each other, or the meta-position to the pyrazole ring of the aryl group to each other, and especially preferably the 3-position of the pyrazole ring to each other.

The partial structure of a ligand may be linked via a single bond or a divalent linking group, but a divalent linking group is preferred. As the examples of the divalent linking groups, e.g., methylene linking, ethylene linking, phenylene linking, nitrogen atom linking, oxygen atom linking, sulfur atom linking, and silicon atom linking are preferred, methylene linking, nitrogen atom linking, and silicon atom linking are more preferred, and methylene linking is especially preferred. As methylene linking groups, a methylene group (-CH₂-), a methylmethylene group (-CHMe-), a fluoromethylmethylene group (-CFMe-), a dimethylmethylene group (-CMe₂-), a methylphenylmethylene group (-CMePh-), a diphenylmethylene group (-CPh₂-), a 9,9-fluorenediyl group, a 1,1-cyclopentanediyl group, and a 1,1-cyclohexanediyl group are specifically exemplified. A dimethylmethylene group, a diphenylmethylene group, a 9,9-fluorenyl group, a 1,1-cyclopentanediyl group, and a 1,1-cyclohexanediyl group are preferred, a dimethylmethylene group, a diphenylmethylene group, and a 1,1-cyclohexanediyl group are more preferred, and a dimethylmethylene group is especially preferred.

As platinum complex (phosphorescent) materials having a tetradentate ligand, one of more preferred materials is a Pt complex represented by formula (A):

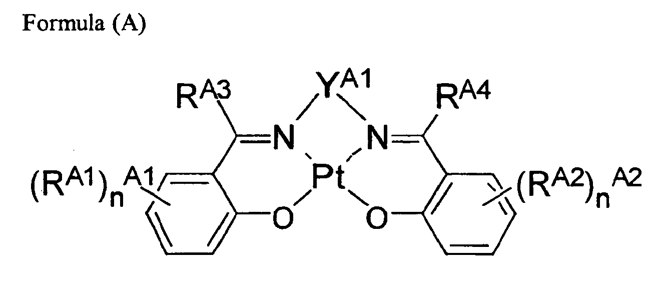

In formula (A), each of R^{A3} and R^{A4} independently represents a hydrogen atom or a substituent; and each of R^{A1} and R^{A2} independently represents a substituent. When a plurality of R^{A1} and R^{A2} are present, the plurality of R^{A1} and R^{A2} may be the same or different, and they may be linked to each other to form a ring. Each of n^{A1} and n^{A2} independently represents an integer of 0 to 4. Y^{A1} represents a linking group.

The substituents represented by R^{A1}, R^{A2}, R^{A3} and R^{A4} can be arbitrarily selected from the following substituent group A.

### Substituent Group A:

An alkyl group (preferably having from 1 to 30 carbon atoms, more preferably from 1 to 20 carbon atoms, and especially preferably from 1 to 10 carbon atoms, e.g., methyl, ethyl, isopropyl, tert-butyl, n-octyl, n-decyl, n-hexadecyl, cyclopropyl, cyclopentyl, cyclohexyl, etc., are exemplified), an alkenyl group (preferably having from 2 to 30 carbon atoms, more preferably from 2 to 20 carbon atoms, and especially preferably from 2 to 10 carbon atoms, e.g., vinyl, allyl, 2-butenyl, 3-pentenyl, etc., are exemplified), an alkynyl group (preferably having from 2 to 30 carbon atoms, more preferably from 2 to 20 carbon atoms, and especially preferably from 2 to 10 carbon atoms, e.g., propargyl, 3-pentynyl, etc., are exemplified), an aryl group (preferably having from 6 to 30 carbon atoms, more preferably from 6 to 20 carbon atoms, and especially preferably from 6 to 12 carbon atoms, e.g., phenyl, p-methylphenyl, naphthyl, anthranyl, etc., are exemplified), an amino group (preferably having from 0 to 30 carbon atoms, more preferably from 0 to 20 carbon atoms, and especially preferably from 0 to 10 carbon atoms, e.g., amino, methylamino, dimethylamino, diethylamino, dibenzylamino, diphenylamino, ditolylamino, etc., are exemplified), an alkoxy group (preferably having from 1 to 30 carbon atoms, more preferably from 1 to 20 carbon atoms, and especially preferably from 1 to 10 carbon atoms, e.g., methoxy, ethoxy, butoxy, 2-ethylhexyloxy, etc., are exemplified), an aryloxy group (preferably having from 6 to 30 carbon atoms, more preferably from 6 to 20 carbon atoms, and especially preferably from 6 to 12 carbon atoms, e.g., phenyloxy, 1-naphthyloxy, 2-naphthyloxy, etc., are exemplified), a heterocyclic oxy group (preferably having from 1 to 30 carbon atoms, more preferably from 1 to 20 carbon atoms, and especially preferably from 1 to 12 carbon atoms, e.g., pyridyloxy, pyrazyloxy, pyrimidyloxy, quinolyloxy, etc., are exemplified), an acyl group (preferably having from 2 to 30 carbon atoms, more preferably from 2 to 20 carbon atoms, and especially preferably from 2 to 12 carbon atoms, e.g., acetyl, benzoyl, formyl, pivaloyl, etc., are exemplified), an alkoxycarbonyl group (preferably having from 2 to 30 carbon atoms, more preferably from 2 to 20 carbon atoms, and especially preferably from 2 to 12 carbon atoms, e.g., methoxycarbonyl, ethoxycarbonyl, etc., are exemplified), an aryloxycarbonyl group (preferably having from 7 to 30 carbon atoms, more preferably from 7 to 20 carbon atoms, and especially preferably from 7 to 12 carbon atoms, e.g., phenyloxycarbonyl, etc., are exemplified), an acyloxy group (preferably having from 2 to 30 carbon atoms, more preferably from 2 to 20 carbon atoms, and especially preferably from 2 to 10 carbon atoms, e.g., acetoxy, benzoyloxy, etc., are exemplified), an acylamino group (preferably having from 2 to 30 carbon atoms, more preferably from 2 to 20 carbon atoms, and especially preferably from 2 to 10 carbon atoms, e.g., acetylamino, benzoylamino, etc., are exemplified), an alkoxycarbonylamino group (preferably having from 2 to 30 carbon atoms, more preferably from 2 to 20 carbon atoms, and especially preferably from 2 to 12 carbon atoms, e.g., methoxycarbonylamino, etc., are exemplified), an aryloxycarbonylamino group (preferably having from 7 to 30 carbon atoms, more preferably from 7 to 20 carbon atoms, and especially preferably from 7 to 12 carbon atoms, e.g., phenyloxycarbonylamino, etc., are exemplified), a sulfonylamino group (preferably having from 1 to 30 carbon atoms, more preferably from 1 to 20 carbon atoms, and especially preferably from 1 to 12 carbon atoms, e.g., methanesulfonylamino, benzenesulfonylamino, etc., are exemplified), a sulfamoyl group (preferably having from 0 to 30 carbon atoms, more preferably from 0 to 20 carbon atoms, and especially preferably from 0 to 12 carbon atoms, e.g., sulfamoyl, methylsulfamoyl, dimethylsulfamoyl, phenylsulfamoyl, etc., are exemplified), a carbamoyl group (preferably having from 1 to 30 carbon atoms, more preferably from 1 to 20 carbon atoms, and especially preferably from 1 to 12 carbon atoms, e.g., carbamoyl, methylcarbamoyl, diethylcarbamoyl, phenylcarbamoyl, etc., are exemplified), an alkylthio group (preferably having from 1 to 30 carbon atoms, more preferably from 1 to 20 carbon atoms, and especially preferably from 1 to 12 carbon atoms, e.g., methylthio, ethylthio, etc., are exemplified), an arylthio group (preferably having from 6 to 30 carbon atoms, more preferably from 6 to 20 carbon atoms, and especially preferably from 6 to 12 carbon atoms, e.g., phenylthio, etc., are exemplified), a heterocyclic thio group (preferably having from 1 to 30 carbon atoms, more preferably from 1 to 20 carbon atoms, and especially preferably from 1 to 12 carbon atoms, e.g., pyridylthio, 2-benzimizolylthio, 2-benzoxazolylthio, 2-benzothiazolylthio, etc., are exemplified), a sulfonyl group (preferably having 1 to 30 carbon atoms, more preferably 1 to 20 carbon atoms, and especially preferably 1 to 12 carbon atoms, e.g., a mesyl group, a tosyl group, etc., are exemplified), a sulfinyl group (preferably having 1 to 30 carbon atoms, more preferably 1 to 20 carbon atoms, and especially preferably 1 to 12 carbon atoms, e.g., a methanesulfinyl group, a benzenesulfinyl group, etc., are exemplified), a ureido group (preferably having 1 to 30 carbon atoms, more preferably 1 to 20 carbon atoms, and especially preferably 1 to 12 carbon atoms, e.g., a ureido group, a methylureido group, a phenylureido group, etc., are exemplified), a phosphoric acid amido group (preferably having 1 to 30 carbon atoms, more preferably 1 to 20 carbon atoms, and especially preferably 1 to 12 carbon atoms, e.g., a diethylphosphoric acid amido group, a phenylphosphoric acid amido group, etc., are exemplified), a hydroxyl group, a mercapto group, a halogen atom (e.g., a fluorine atom, a chlorine atom, a bromine atom, an iodine atom), a cyano group, a sulfo group, a carboxyl group, a nitro group, a hydroxamic acid group, a sulfino group, a hydrazino group, an imino group, a heterocyclic group (preferably having 1 to 30 carbon atoms, and more preferably 1 to 12 carbon atoms, and as the hetero atoms, e.g., a nitrogen atom, an oxygen atom, and a sulfur atom, specifically, e.g., an imidazolyl group, a pyridyl group, a quinolyl group, a furyl group, a thienyl group, a piperidyl group, a morpholino group, a benzoxazolyl group, a benzimidazolyl group, a benzothiazolyl group, a carbazolyl group, and an azepinyl group are exemplified), a silyl group (preferably having 3 to 40 carbon atoms, more preferably 3 to 30 carbon atoms, and especially preferably 3 to 24 carbon atoms, e.g., a trimethylsilyl group, a triphenylsilyl group, etc., are exemplified), a silyloxy group (preferably having 3 to 40 carbon atoms, more preferably 3 to 30 carbon atoms, and especially preferably 3 to 24 carbon atoms, e.g., a trimethylsilyloxy group, a triphenylsilyloxy group, etc., are exemplified), and a phosphoryl group (e.g., a diphenylphosphoryl group, a dimethylphosphoryl group, etc., are exemplified) are exemplified.

The linking groups represented by Y^{A1} can be arbitrarily selected from the following group A of linking groups.

### Group A of Linking Groups:

An alkylene group (e.g., methylene, ethylene, propylene, etc.), an arylene group (e.g., phenylene, naphthalenediyl), a heteroarylene group (e.g., pyridinediyl, thiophenediyl, etc.), an imino group (-NR-) (e.g., a phenylimino group, etc.), an oxy group (-O-), a thio group (-S-), a phosphinidene group (-PR-) (e.g., a phenylphosphinidene group, etc.), a silylene group (-SiRR'-) (e.g., a dimethylsilylene group, a diphenylsilylene group, etc.), and combinations of these groups. These linking groups may further have a substituent.

As the substituents represented by R^{A1}, R^{A2}, R^{A3} and R^{A4}, an alkyl group, an aryl group and a heterocyclic group are preferred, an aryl group and a heterocyclic group are more preferred, and an aryl group is especially preferred.

As the linking groups represented by Y^{A1}, a vinyl group substituted at the 1,2-position, a phenylene ring, a pyridine ring, a pyrazine ring, a pyrimidine ring, and an alkylene group having 1 to 8 carbon atoms are preferred, a vinyl group substituted at the 1,2-position, a phenylene ring, and an alkylene group having 1 to 6 carbon atoms are more preferred, and a phenylene ring is especially preferred.

The substituents represented by R^{A3} and R^{A4} may be linked to the linking group represented by Y^{A1} to form a ring. For example, when Y^{A1} is a phenylene ring linked at the 1,2-position, R^{A3} and R^{A4} may be linked at the 3,6-position to form a 1,10-phenanthroline ring, and may further have a substituent.

As platinum complex (phosphorescent) materials having a tetradentate ligand, one of more preferred materials is a Pt complex represented by formula (B):

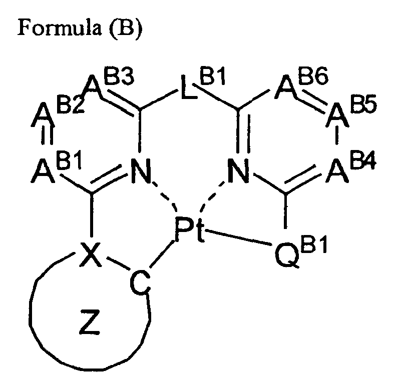

In formula (B), each of A^{B1} to A^{B6} independently represents C-R or N. R represents a hydrogen atom or a substituent. L^{B1} represents a single bond or a divalent linking group. X represents C or N. Z represents a 5- or 6-membered aromatic ring or aromatic heterocyclic ring formed together with X-C in the formula. Q^{B1} represents an anionic group bonding to Pt.

Formula (B) will be described.

Each of A^{B1} to A^{B6} independently represents C-R or N. R represents a hydrogen atom or a substituent. The substituents represented by R are the same as those exemplified above as the substituent group A, and preferred examples are also the same.

Each of A^{B1} to A^{B6} preferably represents C-R, and R's may be linked to each other to form a ring. When each of A^{B1} to A^{B6} represents C-R, R of A^{B2} and A^{B5} is preferably a hydrogen atom, an alkyl group, an aryl group, an amino group, an alkoxy group, an aryloxy group, a fluorine group, or a cyano group, more preferably a hydrogen atom, an amino group, an alkoxy group, an aryloxy group, or a fluorine group, and especially preferably a hydrogen atom or a fluorine group. R of A^{B1}, A^{B3}, A^{B4} and A^{B6} is preferably a hydrogen atom, an alkyl group, an aryl group, an amino group, an alkoxy group, an aryloxy group, a fluorine group, or a cyano group, more preferably a hydrogen atom, an amino group, an alkoxy group, an aryloxy group, or a fluorine group, and especially preferably a hydrogen atom.

L^{B1} represents a single bond or a divalent linking group.

As the divalent linking group represented by L^{B1}, an alkylene group (e.g., methylene, ethylene, propylene, etc.), an arylene group (e.g., phenylene, naphthalenediyl), a heteroarylene group (e.g., pyridinediyl, thiophenediyl, etc.), an imino group (-NR-) (e.g., a phenylimino group, etc.), an oxy group (-O-), a thio group (-S-), a phosphinidene group (-PR-) (e.g., a phenylphosphinidene group, etc.), a silylene group (-SiRR'-) (e.g., a dimethylsilylene group, a diphenylsilylene group, etc.), and combinations of these groups are exemplified. These linking groups may further have a substituent.

L^{B1} preferably represents a single bond, an alkylene group, an arylene group, a heteroarylene group, an imino group, an oxy group, a thio group, or a silylene group, more preferably a single bond, an alkylene group, an arylene group, or an imino group, more preferably an alkylene group, more preferably a methylene group, more preferably a di-substituted methylene group, more preferably a dimethylmethylene group, a diethylmethylene group, a diisobutylmethylene group, a dibenzylmethylene group, an ethylmethylmethylene group, a methylpropylmethylene group, an isobutylmethylmethylene group, a diphenylmethylene group, a methylphenylmethylene group, a cyclohexanediyl group, a cyclopentanediyl group, a fluorenediyl group, or a fluoromethylmethylene group, and especially preferably a dimethylmethylene group, a diphenylmethylene group, or a cyclohexanediyl group.

X represents C or N. Z represents a 5- or 6-membered aromatic hydrocarbon ring or aromatic heterocyclic ring formed together with X-C in the formula. As the aromatic hydrocarbon ring or aromatic heterocyclic ring represented by Z, a benzene ring, a naphthalene ring, an anthracene ring, a pyrene ring, a phenanthrene ring, a perylene ring, a pyridine ring, a quinoline ring, an isoquinoline ring, a phenanthridine ring, a pyrimidine ring, a pyrazine ring, a pyridazine ring, a triazine ring, a cinnoline ring, an acridine ring, a phthalazine ring, a quinazoline ring, a quinoxaline ring, a naphthyridine ring, a pteridine ring, a pyrrole ring, a pyrazole ring, a triazole ring, an indole ring, a carbazole ring, an indazole ring, a benzimidazole ring, an oxazole ring, a thiazole ring, an oxadiazole ring, a thiadiazole ring, a benzoxazole ring, a benzothiazole ring, an imidazopyridine ring, a thiophene ring, a benzothiophene ring, a furan ring, a benzofuran ring, a phosphor ring, a phosphinine ring, and a silol ring are exemplified. Z may have a substituent, and the substituent group A described above can be applied to the substituent. Further, Z may form a condensed ring with other rings.

Z preferably represents a benzene ring, a naphthalene ring, a pyrazole ring, an imidazole ring, a triazole ring, a pyridine ring, an indole ring, or a thiophene ring, and more preferably a benzene ring, a pyrazole ring, or a pyridine ring.

Q^{B1} represents an anionic group bonding to Pt. As the anionic groups represented by Q^{B1}, a vinyl ligand, an aromatic hydrocarbon ring ligand (e.g., a benzene ligand, a naphthalene ligand, an anthracene ligand, a phenanthracene ligand, etc.), a heterocyclic ligand (e.g., a furan ligand, a thiophene ligand, a pyridine ligand, a pyrazine ligand, a pyrimidine ligand, a pyridazine ligand, a triazine ligand, a thiazole ligand, an oxazole ligand, a pyrrole ligand, an imidazole ligand, a pyrazole ligand, a triazole ligand, and condensed rings containing these groups (e.g., a quinoline ligand, a benzothiazole ligand, etc.)) are exemplified. At this time, the bond of Q^{B1} to Pt may be any of a covalent bond, an ionic bond, and a coordinate bond. As the atom in Q^{B1} bonding to Pt, a carbon atom, a nitrogen atom, an oxygen atom, a sulfur atom and a phosphorus atom are preferred, as the atom in Q^{B1} bonding to Pt, a carbon atom, an oxygen atom, and a nitrogen atom are preferred, and a carbon atom is more preferred.

The group represented by Q^{B1} is preferably an aromatic hydrocarbon ring ligand bonding to Pt via a carbon atom, an aromatic heterocyclic ligand bonding to Pt via a carbon atom, a nitrogen-containing aromatic heterocyclic ligand bonding to Pt via a nitrogen atom, or an acyloxy ligand, more preferably an aromatic hydrocarbon ring ligand bonding to Pt via a carbon atom, or an aromatic heterocyclic ligand bonding to Pt via a carbon atom. The group represented by Q^{B1} is particularly preferably the same group as ring Z formed together with C-X in formula (B).

The Pt complex represented by formula (B) is more preferably a Pt complex represented by formula (C):

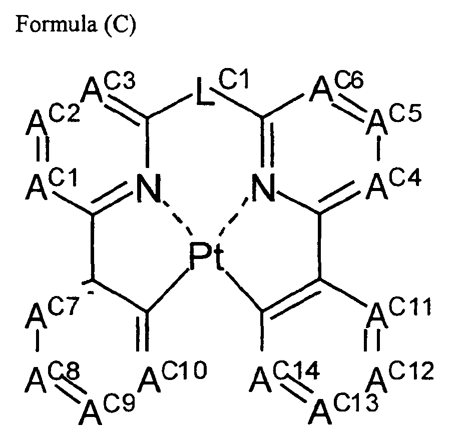

In formula (C), each of A^{C1} to A^{C14} independently represents C-R or N. R represents a hydrogen atom or a substituent. L^{C1} represents a single bond or a divalent linking group.

Formula (C) will be described.

Each of A^{C1} to A^{C14} independently represents C-R or N. R represents a hydrogen atom or a substituent. A^{C1} to A^{C6} have the same meaning as A^{B1} to A^{B6} in formula (B) and the preferred ranges are also the same.

As for A^{C7} to A^{C14}, in each of A^{C7} to A^{C10} and A^{C11} to A^{C14}, the number of the one representing N (a nitrogen atom) is preferably 0 to 2, and more preferably 0 or 1. Those representing N are preferably selected from A^{C8} to A^{C10} and A^{C12} to A^{C14}, more preferably selected from A^{C8}, A^{C9}, A^{C12} and A^{C13}, and especially preferably selected from A^{C8} and A^{C12}.

When each of A^{C7} to A^{C14} represents C-R, R represented by A^{C8} and A^{C12} is preferably a hydrogen atom, an alkyl group, a polyfluoroalkyl group, an aryl group, an amino group, an alkoxy group, an aryloxy group, a fluorine group, or a cyano group, more preferably a hydrogen atom, a polyfluoroalkyl group, an alkyl group, an aryl group, a fluorine group, or a cyano group, and especially preferably a hydrogen atom, a polyfluoroalkyl group, or a cyano group. R represented by A^{C7}, A^{C9}, A^{C11} and A^{C13} is preferably a hydrogen atom, an alkyl group, a polyfluoroalkyl group, an aryl group, an amino group, an alkoxy group, an aryloxy group, a fluorine group, or a cyano group, more preferably a hydrogen atom, a polyfluoroalkyl group, a fluorine group, or a cyano group, and especially preferably a hydrogen atom or a fluorine group. R represented by A^{C10} and A^{C14} is preferably a hydrogen atom or a fluorine group, and more preferably a hydrogen atom. When any of A^{C7} to A^{C9} and A^{C11} to A^{C13} represents C-R, R's may be linked to each other to form a ring.

The linking group represented by L^{C1} has the same meaning as that of the linking group represented by L^{B1} in formula (B) and the preferred range is also the same.

The Pt complex represented by formula (B) is more preferably a Pt complex represented by formula (D):

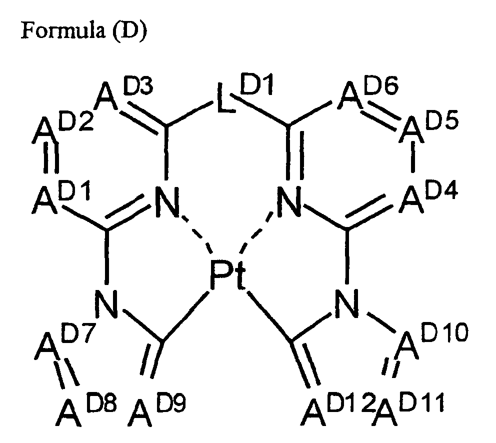

In formula (D), each of A^{D1} to A^{D12} independently represents C-R or N. R represents a hydrogen atom or a substituent. L^{D1} represents a single bond or a divalent linking group.

Formula (D) will be described.

Each of A^{D1} to A^{D12} independently represents C-R or N. R represents a hydrogen atom or a substituent.

A^{D1} to A^{D6} have the same meaning as the substituents represented by A^{B1} to A^{B6} in formula (B) and the preferred ranges are also the same.

As for A^{D7} to A^{D12}, in each of A^{D7} to A^{D9} and A^{D10} to A^{D12}, the number of the one representing N (a nitrogen atom) is preferably 0 to 2, more preferably 1 or 2, and especially preferably 1. Those representing N are preferably selected from A^{D7} to A^{D9} and A^{D10} to A^{D12}, more preferably selected from A^{D7}, A^{D9}, A^{D10} and A^{D12}, and especially preferably selected from A^{D7} and A^{D10}.

When each of A^{D7} to A^{D12} represents C-R, R represented by A^{D8} and A^{D11} is preferably a hydrogen atom, an alkyl group, a polyfluoroalkyl group, an aryl group, an amino group, an alkoxy group, an aryloxy group, a fluorine group, or a cyano group, more preferably a hydrogen atom, a polyfluoroalkyl group, an alkyl group, an aryl group, a fluorine group, or a cyano group, and especially preferably a polyfluoroalkyl group (e.g., a trifluoromethyl group and a perfluoroethyl group), or a cyano group. R represented by A^{D7}, A^{D9}, A^{D10} and A^{D12} is preferably a hydrogen atom, an alkyl group, a polyfluoroalkyl group, an aryl group, an amino group, an alkoxy group, an aryloxy group, a fluorine group, or a cyano group, more preferably a hydrogen atom or a fluorine group, and especially preferably a hydrogen atom. When any of A^{D7} to A^{D12} represents C-R, R's may be linked to each other to form a ring.

The linking group represented by L^{D1} has the same meaning as that of the linking group represented by L^{B1} in formula (B) and the preferred range is also the same.

As platinum complex (phosphorescent) materials having a tetradentate ligand, one of more preferred materials is a Pt complex represented by formula (E):

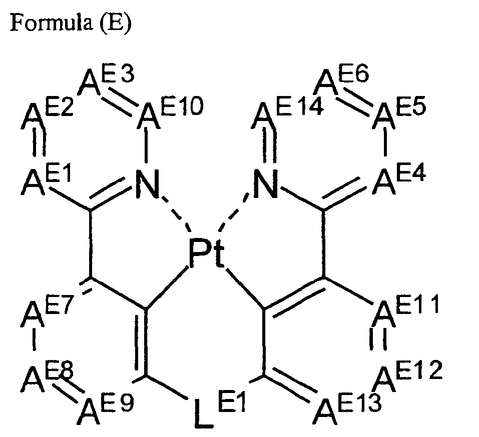

In formula (E), each of A^{E1} to A^{E14} independently represents C-R or N. R represents a hydrogen atom or a substituent. L^{E1} represents a single bond or a divalent linking group.

Formula (E) will be described. Each of A^{E1} to A^{E12} independently represents C-R or N. R represents a hydrogen atom or a substituent. A^{E1} to A^{E6} have the same meaning as A^{B1} to A^{B6} in formula (B) and the preferred ranges are also the same. A^{E7} to A^{E14} have the same meaning as A^{C7} to A^{C14} in formula (C) and the preferred ranges are also the same.

The linking group represented by L^{E1} has the same meaning as that of the linking group represented by L^{B1} in formula (B).

L^{E1} preferably represents a single bond, an alkylene group, an arylene group, a heteroarylene group, an imino group, an oxy group, a thio group, or a silylene group, more preferably an alkylene group, an imino group, an oxy group, a thio group, or a silylene group, more preferably an alkylene group, more preferably a methylene group, more preferably a di-substituted methylene group, more preferably a dimethylmethylene group, a diethylmethylene group, a diisobutylmethylene group, a dibenzylmethylene group, an ethylmethylmethylene group, a methylpropylmethylene group, an isobutylmethylmethylene group, a diphenylmethylene group, a methylphenylmethylene group, a cyclohexanediyl group, a cyclopentanediyl group, a fluorenediyl group, or a fluoromethylmethylene group, and especially preferably a dimethylmethylene group, a diphenylmethylene group, or a cyclohexanediyl group.

As platinum complex (phosphorescent) materials having a tetradentate ligand, one of more preferred materials is a Pt complex represented by formula (F):

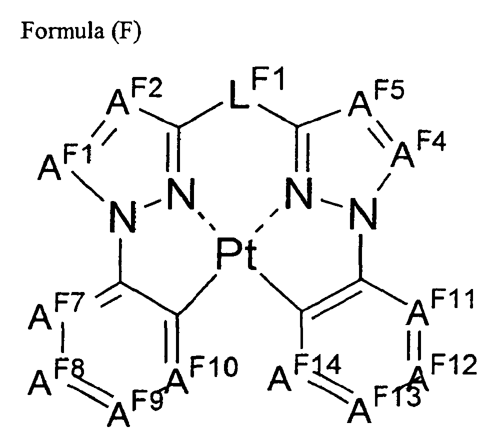

In formula (F), each of A^{F1} to A^{F14} independently represents C-R or N. R represents a hydrogen atom or a substituent. L^{F1} represents a single bond or a divalent linking group.

Formula (F) will be described.

Each of A^{F1} to A^{F14} independently represents C-R or N. R represents a hydrogen atom or a substituent. A^{F1} to A^{F5} have the same meaning as A^{B1} to A^{B5} in formula (B). Each of A^{F1} to A^{F5} preferably represents C-R, and R's may be linked to each other to form a ring. When each of A^{F1} to A^{F5} represents C-R, R of A^{F1} to A^{F5} is preferably a hydrogen atom, an alkyl group, an aryl group, an amino group, an alkoxy group, an aryloxy group, a fluorine group, or a cyano group, more preferably a hydrogen atom, an aryl group, a fluorine group, or a cyano group, and especially preferably a hydrogen atom.

A^{F7} to A^{F14} have the same meaning as A^{C7} to A^{C14} in formula (C) and the preferred ranges are also the same. In particular, when any of A^{F7} to A^{F9} and A^{F11} to A^{F13} represents C-R, a ring structure formed by R's by linking to each other is preferably a furan ring, a benzofuran ring, a pyrrole ring, a benzopyrrole ring, a thiophene ring, a benzothiophene ring, or a fluorene ring, and these rings may further have a substituent.

The linking group represented by L^{F1} has the same meaning as that of the linking group represented by L^{B1} in formula (B), and the preferred range is also the same.

As the specific examples of light-emitting dopants, the following compounds are exemplified, but the invention is not restricted thereto.

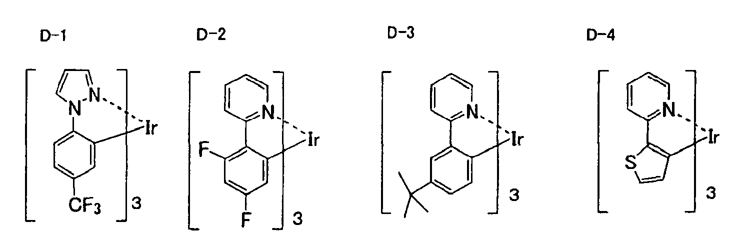

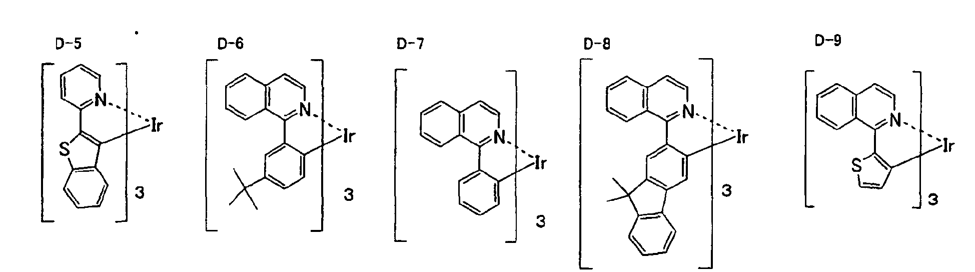

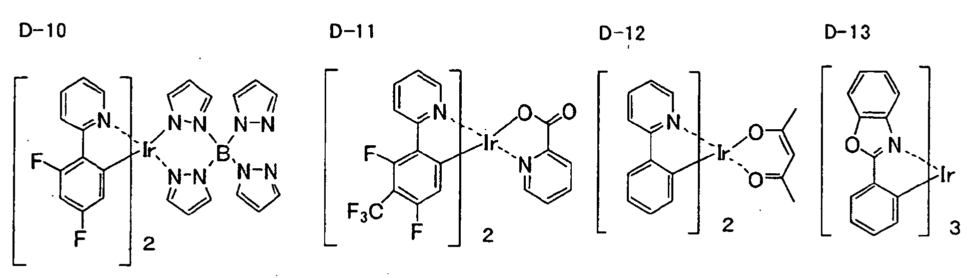

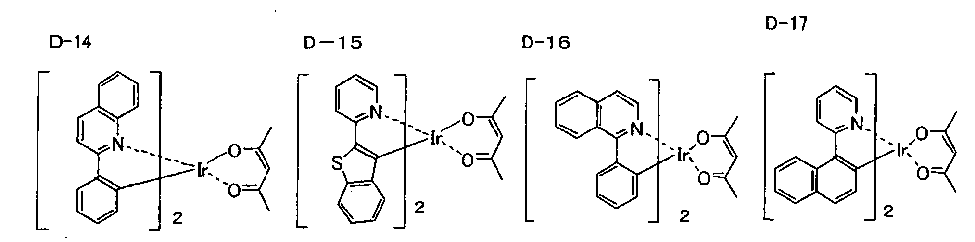

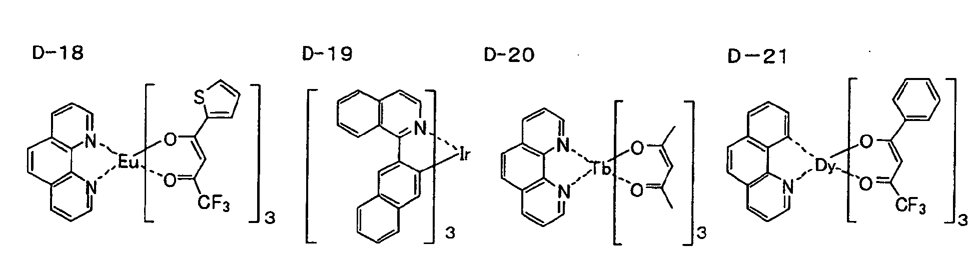

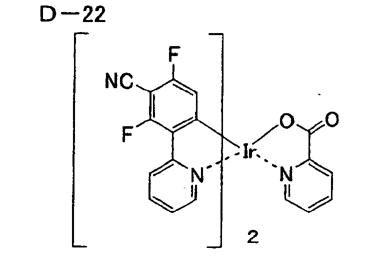

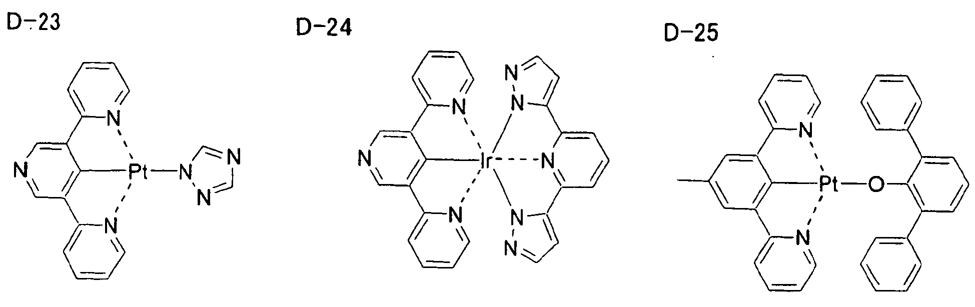

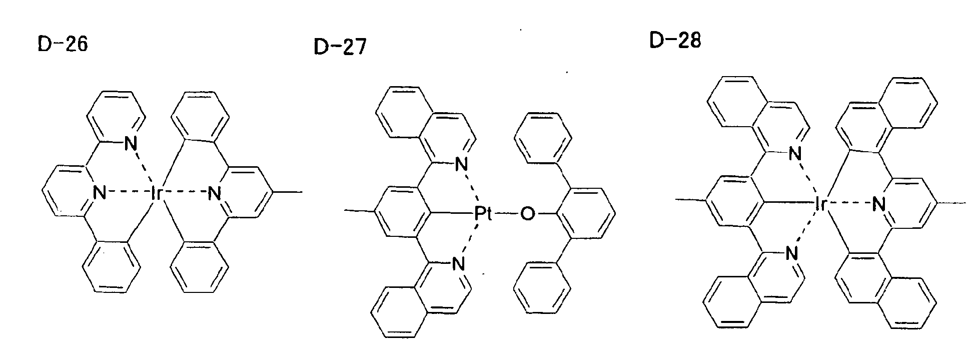

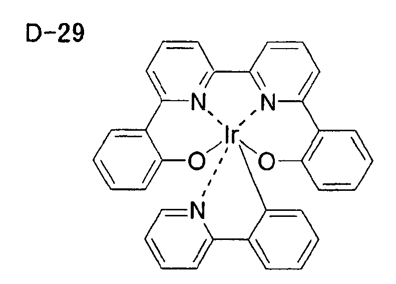

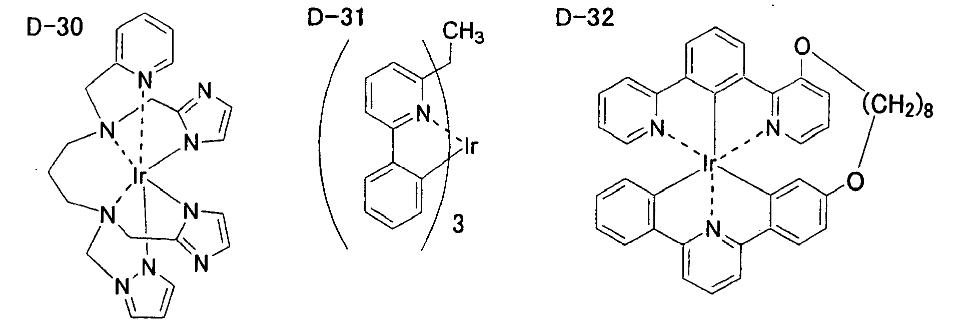

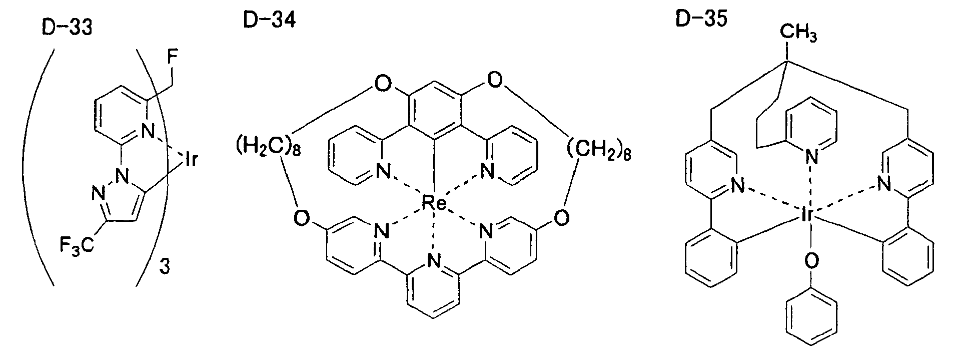

As the examples of platinum complex phosphorescent materials having a tetradentate ligand, for example, the following compounds are exemplified, but the invention is not restricted thereto.

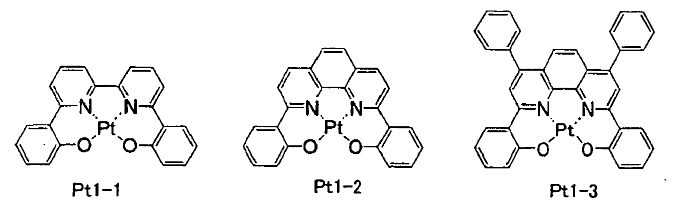

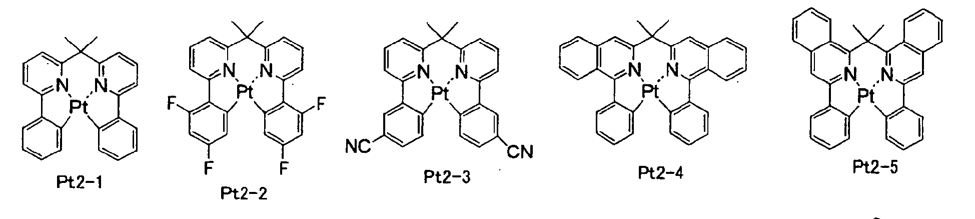

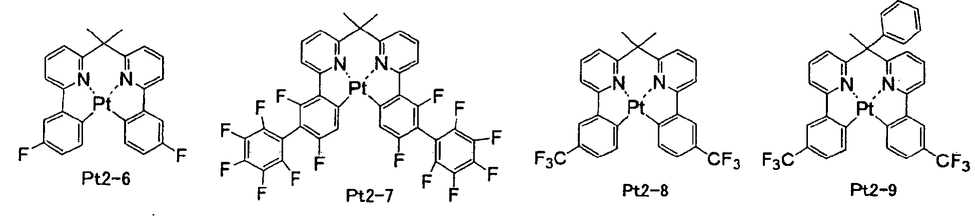

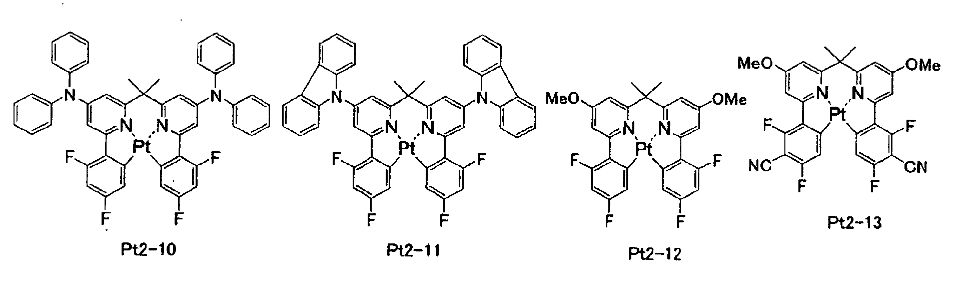

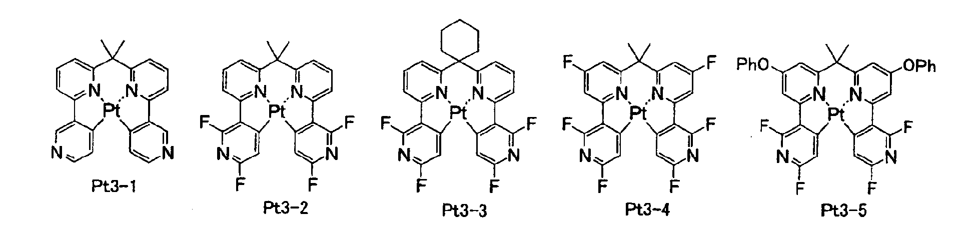

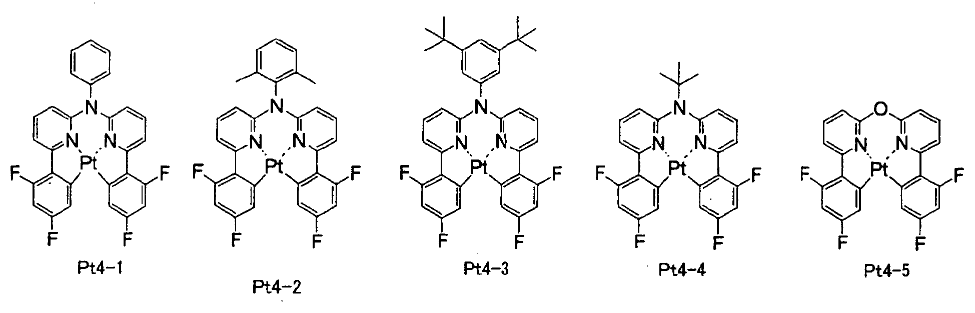

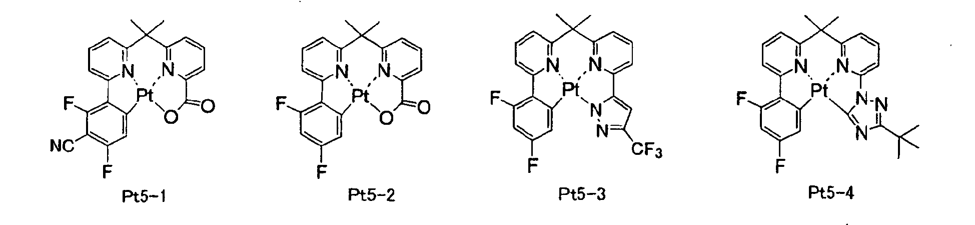

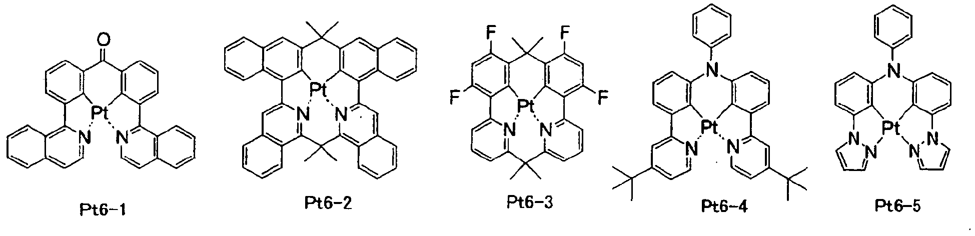

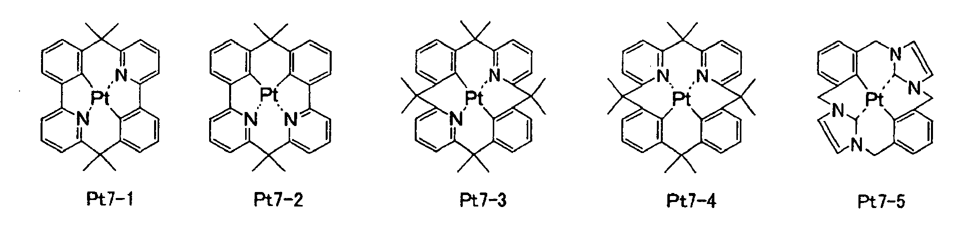

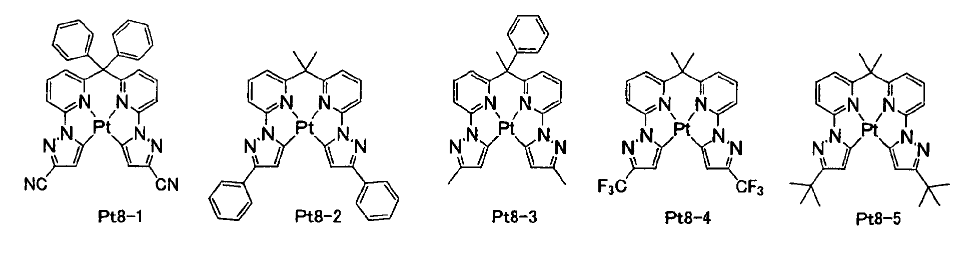

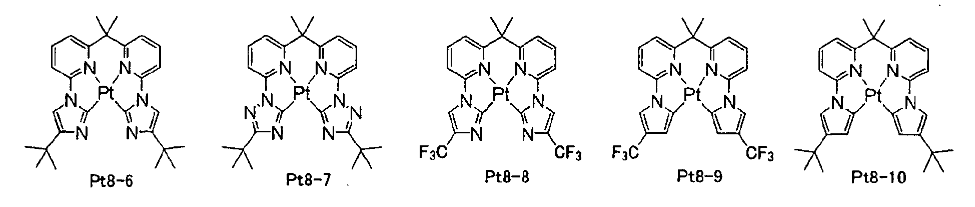

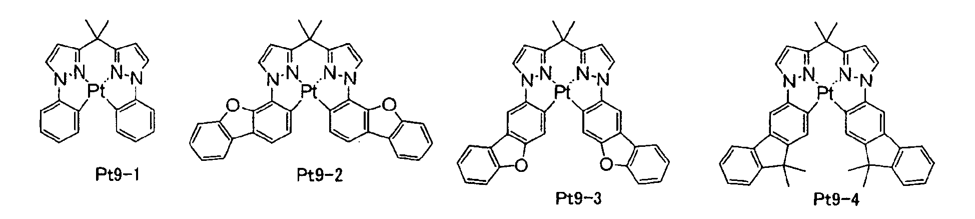

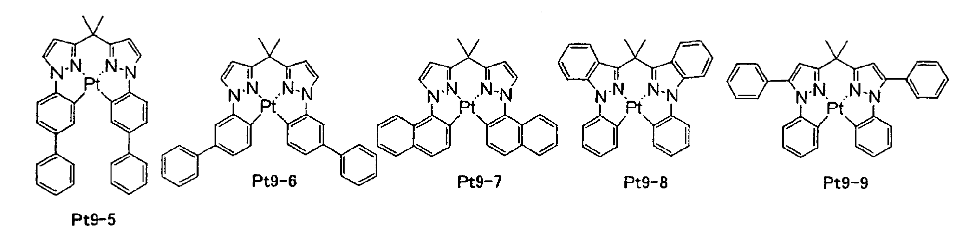

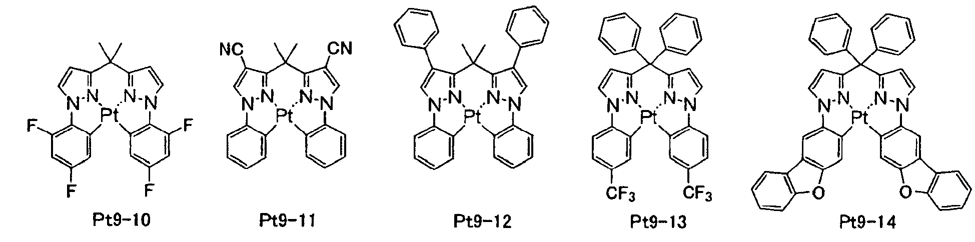

A light-emitting dopant (a light-emitting material) in a light-emitting layer is generally contained in an amount of 0.1 to 50 wt.% to the mass of all the compounds to form the light-emitting layer, but the amount is preferably 1 to 50 wt.% in view of durability and external quantum efficiency, and more preferably 2 to 40 wt.%.

The thickness of a light-emitting layer is not especially restricted, but generally preferably 2 to 500 nm, and more preferably 3 to 200 nm in the viewpoint of external quantum efficiency, and still more preferably 5 to 100 nm.

### Host Material:

As host materials for use in the invention, a hole-transporting host material (which is sometimes described as a hole-transporting host) excellent in a hole-transporting property and an electron-transporting host compound (which is sometimes described as an electron-transporting host) excellent in an electron-transporting property can be used.

### Hole-Transporting Host:

As hole-transporting hosts for use in the invention, specifically the following materials can be exemplified.

Pyrrole, indole, carbazole, azaindole, azacarbazole, triazole, oxazole, oxadiazole, pyrazole, imidazole, thiophene, polyarylalkane, pyrazoline, pyrazolone, phenylenediamine, arylamine, amino-substituted chalcone, styryl anthracene, fluorenone, hydrazone, stilbene, silazane, aromatic tertiary amine compounds, styrylamine compound, aromatic dimethylidyne-based compound, porphyrin-based compound, polysilane-based compound, poly(N-vinylcarbazole), aniline-based copolymer, thiophene oligomer, electrically conductive high molecular weight oligomer such as polythiophene, organic silane, carbon film, and derivatives thereof are exemplified.

As hole-transporting hosts, preferably indole derivatives, carbazole derivatives, aromatic tertiary amine compounds, and thiophene derivatives are preferably exemplified, more preferably compounds having a carbazole group or an indole group in the molecule, and particularly preferably compounds having a carbazole group are exemplified.

As the compound having a carbazole group, a compound represented by formula (V) is preferred.

The compound represented by formula (V) will be described.

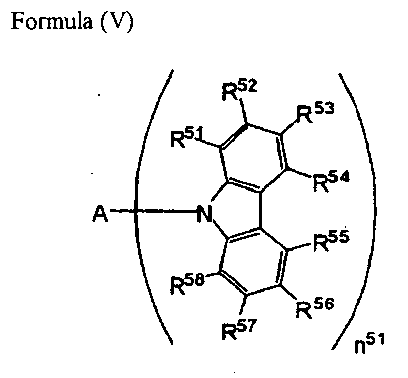

In formula (V), each of R⁵¹ to R⁵⁸ represents a hydrogen atom, a deuterium atom, or a substituent, and contiguous substituents of R⁵¹ to R⁵⁸ may form a condensed ring. A represents a linking group, and n⁵¹ represents an integer of 2 to 6.

The substituents represented by R⁵¹ to R⁵⁸ are not especially restricted, and, for example, an alkyl group, an alkenyl group, an alkynyl group, an aryl group, a heteroaryl group, an amino group, an alkoxy group, an aryloxy group, a heterocyclic oxy group, an acyl group, an alkoxycarbonyl group, an aryloxycarbonyl group, an acyloxy group, an acylamino group, an alkoxycarbonylamino group, an aryloxycarbonylamino group, a sulfonylamino group, a sulfamoyl group, a carbamoyl group, an alkylthio group, an arylthio group, a heterocyclic thio group, a sulfonyl group, a sulfinyl group, a ureido group, a phosphoric acid amide group, a hydroxy group, a mercapto group, a halogen atom, a cyano group, a sulfo group, a carboxyl group, a nitro group, a hydroxamic acid group, a sulfino group, a hydrazino group, an imino group, a heterocyclic group, a silyl group, and a silyloxy group are exemplified. These substituents may further be substituted with other substituent, and these substituents may be bonded to each other to form a ring.

Each of R⁵¹ to R⁵⁸ preferably represents a hydrogen atom, a deuterium atom, an alkyl group, an aryl group, a heteroaryl group, a halogen group, a cyano group, or a silyl group, more preferably a hydrogen atom, a deuterium atom, an alkyl group, a heteroaryl group, a halogen group, a cyano group, or a silyl group, and especially preferably a hydrogen atom, a deuterium atom, an alkyl group, a heteroaryl group, or a silyl group. R⁵¹ to R⁵⁸ may further be substituted with other substituents, and these substituents may be bonded to each other to form a ring.

As the alkyl groups represented by R⁵¹ to R⁵⁸, methyl, ethyl, n-propyl, isopropyl, n-butyl, tert-butyl, n-octyl, cyclopropyl, cyclopentyl, cyclohexyl, 1-adamantyl, and trifluoromethyl are preferred, methyl, isopropyl, tert-butyl, n-octyl, cyclopentyl, cyclohexyl, 1-adamantyl, and trifluoromethyl are more preferred, and tert-butyl, cyclohexyl, 1-adamantyl, and trifluoromethyl are especially preferred. These substituents may further be substituted with other substituents, and these substituents may be bonded to each other to form a ring.

As the heteroaryl groups represented by R⁵¹ to R⁵⁸, imidazolyl, pyrazolyl, pyridyl, quinolyl, isoquinolinyl, pyrrolyl, indolyl, furyl, thienyl, benzoxazolyl, benzimidazolyl, benzothiazolyl, carbazolyl, and azepinyl are preferred, imidazolyl, pyrazolyl, quinolyl, indolyl, furyl, thienyl, benzimidazolyl, carbazolyl, and azepinyl are more preferred, and indolyl, furyl, thienyl, benzimidazolyl, carbazolyl, and azepinyl are especially preferred. These substituents may further be substituted with other substituents, they may form a condensed structure, and these substituents may be bonded to each other to form a ring.

As the silyl groups represented by R⁵¹ to R⁵⁸, trimethylsilyl, triethylsilyl, triisopropylsilyl, methyldiphenylsilyl, dimethyl-tert-butylsilyl, dimethylphenylsilyl, diphenyl-tert-butylsilyl, and triphenylsilyl are preferably exemplified, trimethylsilyl, triisopropylsilyl, dimethyl-tert-butylsilyl, diphenyl-tert-butylsilyl, and triphenylsilyl are more preferred, and trimethylsilyl, dimethyl-tert-butylsilyl, and triphenylsilyl are especially preferred. These substituents may further be substituted with other substituents, and these substituents may be bonded to each other to form a ring.

n⁵¹ is preferably 2 to 4, more preferably 2 or 3, and especially preferably 2.

Linking groups represented by A are preferably alkylene, arylene, heteroarylene, and silylene, more preferably arylene and heteroarylene, and especially preferably arylene. These linking groups may further be substituted with, for example, the substituents represented by R⁵¹ to R⁵⁸ described above.

As the arylene, preferably phenylene, naphthylene, biphenylene and terphenylene are exemplified, more preferably phenylene and biphenylene, and especially preferably phenylene.

As the phenylene, 1,2,3,4,5,6-hexa-substituted phenylene, 1,2,4,5-tetra-substituted phenylene, 1,3,5-tri-substituted phenylene, 1,2-di-substituted phenylene, 1,3-di-substituted phenylene, and 1,4-di-substituted phenylene are preferably exemplified, more preferably 1,2-di-substituted phenylene, 1,3-di-substituted phenylene, and 1,4-di-substituted phenylene, and especially preferably 1,3-di-substituted phenylene and 1,4-di-substituted phenylene are exemplified.

As the heteroarylene, preferably di-substituted pyridylene and di-substituted N-phenylcarbazolylene are exemplified, more preferably 2,6-di-substituted pyridylene, 3,5-di-substituted pyridylene, and 3,6-di-substituted N-phenylcarbazolylene, and especially preferably 3,6-di-substituted N-phenylcarbazolylene.

As the compounds having a carbazole group, for example, the following compounds are exemplified.

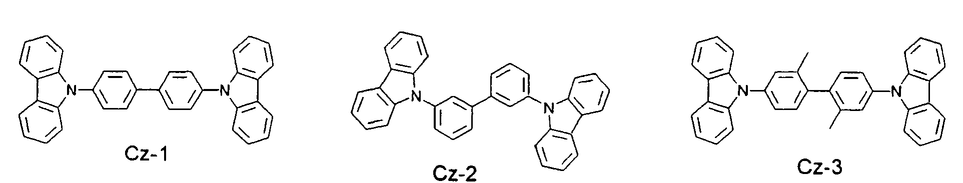

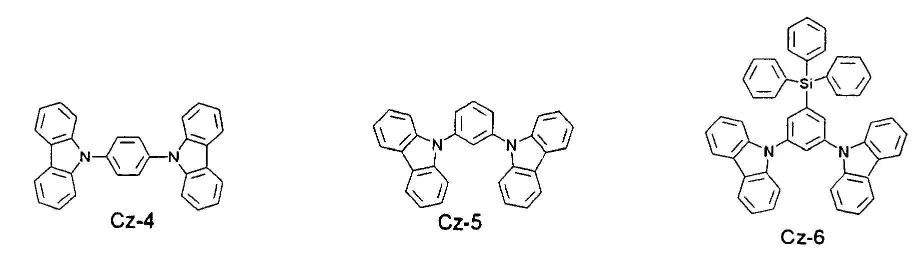

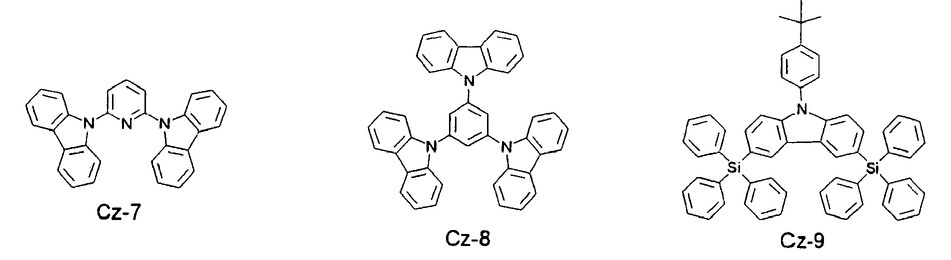

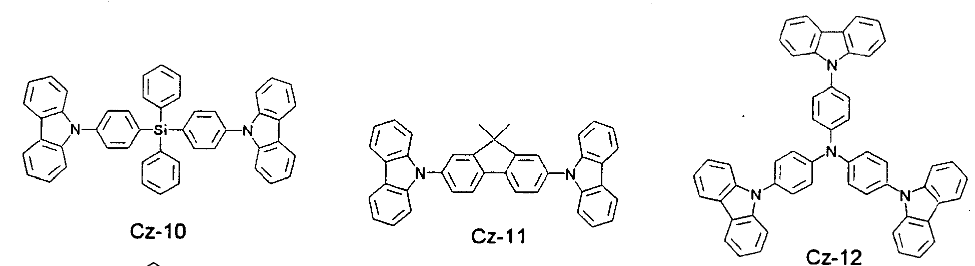

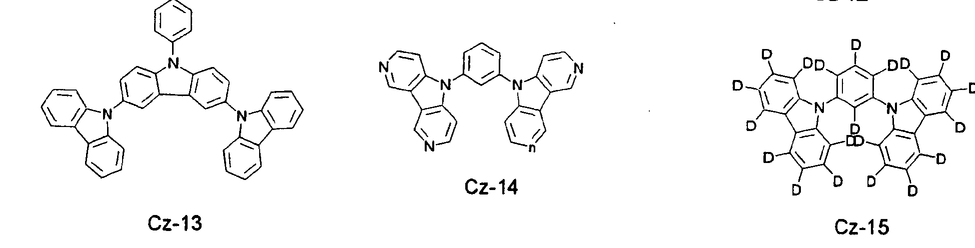

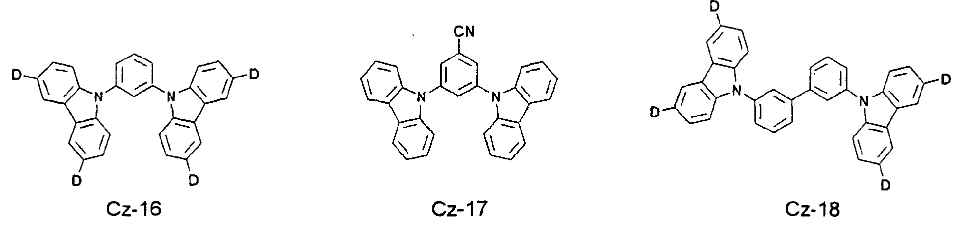

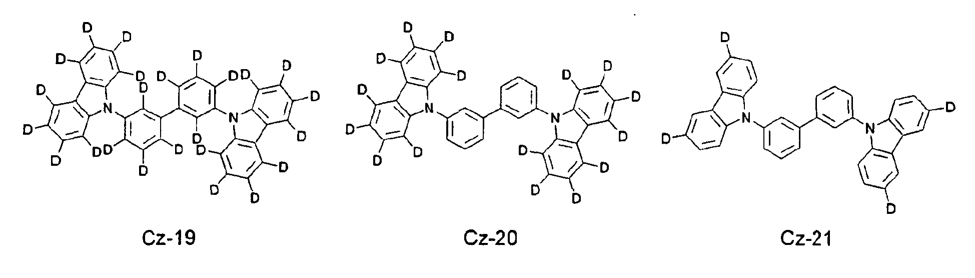

### Electron-Transporting Host:

Electron-transporting hosts for use in a light-emitting layer in the invention preferably have electron affinity Ea of 2.5 eV or more and 3.5 eV or less from the aspects of improvement of durability and reduction of driving voltage, more preferably 2.6 eV or more and 3.4 eV or less, and still more preferably 2.8 eV or more and 3.3 eV or less. In addition, from the aspects of improvement of durability and reduction of driving voltage, it is preferred for the electron-transporting hosts to have ionization potential Ip of 5.7 eV or more and 7.5 eV or less, more preferably 5.8 eV or more and 7.0 eV or less, and still more preferably 5.9 eV or more and 6.5 eV or less.

As such electron-transporting hosts, specifically, for example, the following materials can be exemplified.

Pyridine, pyrimidine, triazine, imidazole, pyrazole, triazole, oxazole, oxadiazole, fluorenone, anthraquinodimethane, anthrone, diphenylquinone, thiopyran dioxide, carbodiimide, fluorenylidenemethane, distyrylpyrazine, fluorine-substituted aromatic compounds, heterocyclic tetracarboxylic anhydride such as naphthaleneperylene, phthalocyanine, and derivatives of these compounds (condensed rings may be formed with other rings), and various metal complexes represented by metal complexes of 8-quinolynol derivatives and metal complexes having metal phthalocyanine, benzoxazole, or benzothiazole as the ligand can be exemplified.

As electron-transporting hosts, metal complexes, azole derivatives (benzimidazole derivatives, imidazopyridine derivatives, etc.), and azine derivatives (pyridine derivatives, pyrimidine derivatives, triazine derivatives, etc.) are preferred, and metal complex compounds are preferred in the invention from the point of durability. As metal complex compounds (A), metal complexes having a ligand having at least one nitrogen atom or oxygen atom or sulfur atom coordinating to metal are more preferred.

Metal ions in metal complexes are not especially restricted, but a beryllium ion, a magnesium ion, an aluminum ion, a gallium ion, a zinc ion, an indium ion, a tin ion, a platinum ion and a palladium ion are preferred, a beryllium ion, an aluminum ion, a gallium ion, a zinc ion, a platinum ion and a palladium ion are more preferred, and an aluminum ion, a zinc ion, and a platinum ion are still more preferred.

Various well-known ligands are contained as the ligands in the metal complexes, for example, the ligands described in H. Yersin, Photochemistry and Photophysics of Coordination Compounds, Springer-Verlag (1987), and Akio Yamamoto, Yuki Kinzoku Kagaku -Kiso to Oyo- (Organic Metal Chemistry -Elements and Applications), Shokabo Publishing Co., Ltd. (1982) are exemplified.

The ligands are preferably nitrogen-containing heterocyclic ligands (preferably having 1 to 30 carbon atoms, more preferably 2 to 20 carbon atoms, and especially preferably 3 to 15 carbon atoms), which may be monodentate ligands or may be bidentate or higher polydentate ligands. Bidentate or higher and hexadentate or lower ligands are preferred. Mixed ligands of bidentate or higher and hexadentate or lower ligands with monodentate ligands are also preferred.

As the ligands, for example, an azine ligand (e.g., a pyridine ligand, a bipyridyl ligand, a terpyridine ligand), a hydroxyphenylazole ligand (e.g., a hydroxyphenylbenzimidazole ligand, a hydroxyphenylbenzoxazole ligand, a hydroxyphenylimidazole ligand, a hydroxyphenylimidazopyridine ligand), an alkoxy ligand (preferably having 1 to 30 carbon atoms, more preferably 1 to 20 carbon atoms, and especially preferably 1 to 10 carbon atoms, e.g., methoxy, ethoxy, butoxy, 2-ethylhexyloxy), an aryloxy ligand (preferably having 6 to 30 carbon atoms, more preferably 6 to 20 carbon atoms, and especially preferably 6 to 12 carbon atoms, e.g., phenyloxy, 1-naphthyloxy, 2-naphthyloxy, 2,4,6-trimethylphenyloxy, 4-biphenyloxy), a heteroaryloxy ligand (preferably having 1 to 30 carbon atoms, more preferably 1 to 20 carbon atoms, and especially preferably 1 to 12 carbon atoms, e.g., pyridyloxy, pyrazyloxy, pyrimidyloxy, quinolyloxy), an alkylthio ligand (preferably having 1 to 30 carbon atoms, more preferably 1 to 20 carbon atoms, and especially preferably 1 to 12 carbon atoms, e.g., methylthio, ethylthio), an arylthio ligand (preferably having 6 to 30 carbon atoms, more preferably 6 to 20 carbon atoms, and especially preferably 6 to 12 carbon atoms, e.g., phenylthio), a heteroarylthio ligand (preferably having 1 to 30 carbon atoms, more preferably 1 to 20 carbon atoms, and especially preferably 1 to 12 carbon atoms, e.g., pyridylthio, 2-benzimidazolylthio, 2-benzoxazolylthio, 2-benzothiazolylthio), a siloxy ligand (preferably having 1 to 30 carbon atoms, more preferably 3 to 25 carbon atoms, and especially preferably 6 to 20 carbon atoms, e.g., a triphenylsiloxy group, a triethoxysiloxy group, triisopropylsiloxy group), an aromatic hydrocarbon anion ligand (preferably having 6 to 30 carbon atoms, more preferably 6 to 25 carbon atoms, and especially preferably 6 to 20 carbon atoms, e.g., a phenyl anion, a naphthyl anion, an anthranyl anion), an aromatic heterocyclic anion ligand (preferably having 1 to 30 carbon atoms, more preferably 2 to 25 carbon atoms, and especially preferably 2 to 20 carbon atoms, e.g., a pyrrole anion, a pyrazole anion, a triazole anion, an oxazole anion, a benzoxazole anion, a thiazole anion, a benzothiazole anion, a thiophene anion, a benzothiophene anion), and an indolenine anion ligand are exemplified. Of these ligands, a nitrogen-containing heterocyclic ligand, an aryloxy ligand, a heteroaryloxy group, and a siloxy ligand are preferred, and a nitrogen-containing heterocyclic ligand, an aryloxy ligand, a siloxy ligand, an aromatic hydrocarbon anion ligand, and an aromatic heterocyclic anion ligand are more preferred.

As the examples of metal complex electron-transporting hosts, the compounds disclosed, for example, in JP-A-2002-235076, JP-A-2004-214179, JP-A-2004-221062, JP-A-2004-221065, JP-A-2004-221068, and JP-A-2004-327313 are exemplified.

It is preferred in the light-emitting layer in the invention that the triplet lowest excitation level (T1) of the host material is higher than T1 of the phosphorescent material in view of color purity, light emission efficiency and driving durability.

The content of the host compound in the invention is not especially restricted, but from light emission efficiency and driving voltage, the content is preferably 15 wt.% or more and 99.9 wt.% or less based on the mass of all the compounds forming the light-emitting layer, more preferably 50 wt.% or more and 99.9 wt.% or less, and still more preferably 80 wt.% or more and 99.9 wt.% or less.

### Hole-Injecting Layer And Hole-Transporting Layer:

A hole-injecting layer and a hole-transporting layer are layers having functions of receiving holes from the anode or anode side and transporting the holes to the cathode side. The hole injecting material and hole transporting material used in these layers may be a low molecular weight compound or may be a polymer compound.

Specifically, these layers are preferably layers containing pyrrole derivatives, carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidyne-based compounds, phthalocyanine-based compounds, porphyrin-based compounds, thiophene derivatives, organic silane derivatives, or carbon. More preferably, they are layers containing pyrrole derivatives, carbazole derivatives, imidazole derivatives, phenylenediamine derivatives, arylamine derivatives, porphyrin-based compounds, thiophene derivatives, or organic silane derivatives, and still more preferably carbazole derivatives, phenylenediamine derivatives, or arylamine derivatives.

When the hydrocarbon compound having an alkyl structure of the invention is contained in the hole-injecting layer and hole-transporting layer, the hole-injecting material and hole-transporting material used together are preferably indole derivatives, carbazole derivatives, aromatic tertiary amine compounds, or thiophene derivatives, more preferably aromatic tertiary amine compounds, or materials having a carbazole group in the molecule, and especially preferably aromatic tertiary amine compounds.

As the aromatic tertiary amine compounds, for example, the following compounds are exemplified.

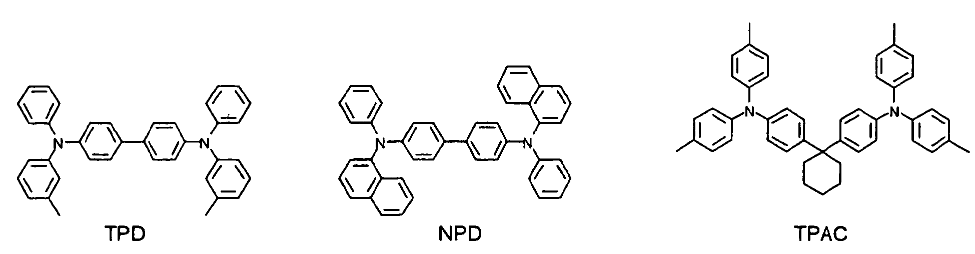

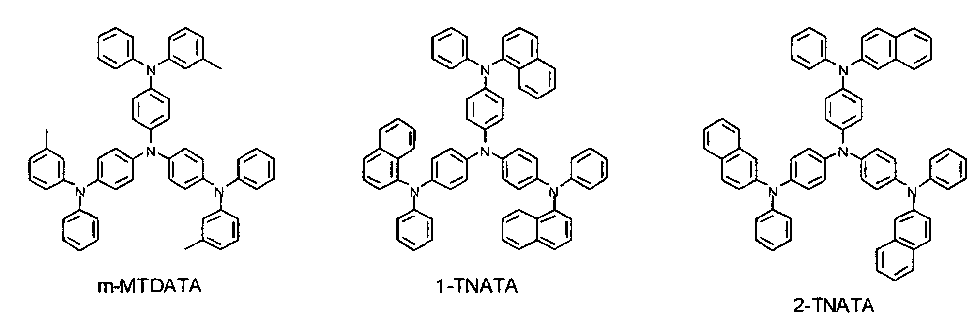

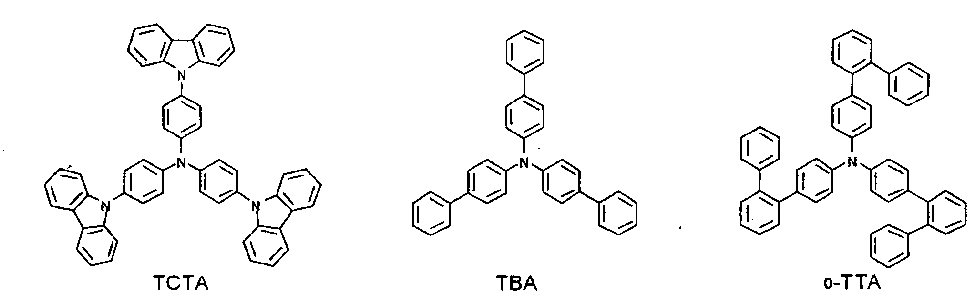

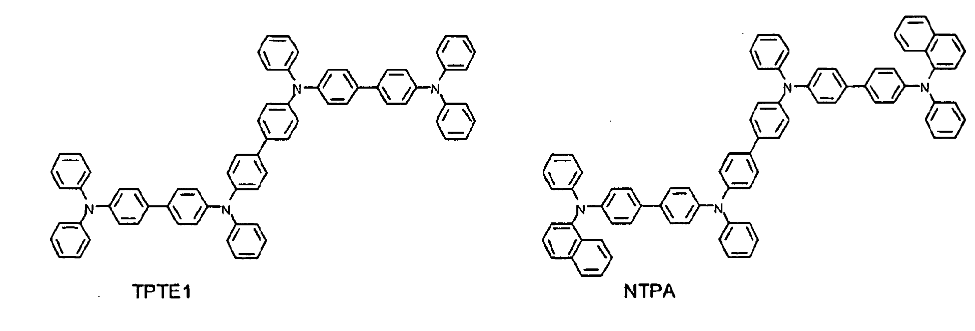

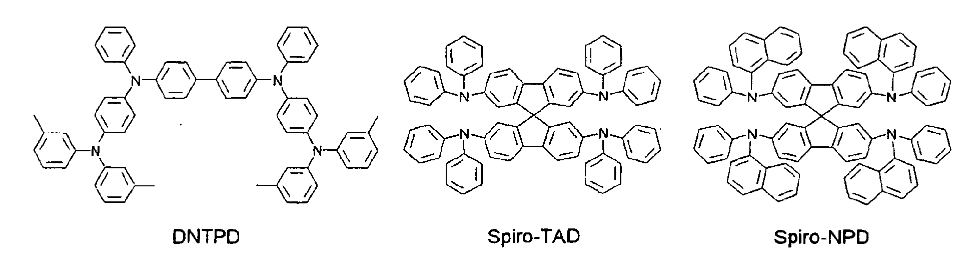

The hole injecting layer or hole transporting layer of the organic EL device in the invention can contain an electron accepting dopant. As the electron accepting dopants to be introduced to the hole injecting layer or hole transporting layer, either inorganic compounds or organic compounds can be used so long as they are electron-acceptive and have a property capable of oxidizing organic compounds.

Specifically, the examples of the inorganic compounds include metal halides, such as ferric chloride, aluminum chloride, gallium chloride, indium chloride, and antimony pentachloride, and metallic oxides, such as vanadium pentoxide and molybdenum trioxide.

In the case of organic compounds, compounds having a nitro group, halogen, a cyano group or a trifluoromethyl group as the substituent, quinone compounds, acid anhydride compounds and Fullerene can be preferably used.

In addition to the above compounds, the compounds disclosed in JP-A-6-212153, JP-A-11-111463, JP-A-11-251067, JP-A-2000-196140, JP-A-2000-286054, JP-A-2000-315580, JP-A-2001-102175, JP-A-2001-160493, JP-A-2002-252085, JP-A-2002-56985, JP-A-2003-157981, JP-A-2003-217862, JP-A-2003-229278, JP-A-2004-342614, JP-A-2005-72012, JP-A-2005-166637 and JP-A-2005-209643 can be preferably used.

Of the compounds, hexacyanobutadiene, hexacyanobenzene, tetracyanoethylene, tetracyanoquinodimethane, tetrafluorotetracyanoquinodimethane, p-fluoranyl, p-chloranyl, p-bromanyl, p-benzoquinone, 2,6-dichlorobenzoquinone, 2,5-dichlorobenzoquinone, 1,2,4,5-tetracyanobenzene, 1,4-dicyanotetrafluorobenzene, 2,3-dichloro-5,6-dicyanobenzoquinone, p-dinitrobenzene, m-dinitrobenzene, o-dinitrobenzene, 1,4-naphthoquinone, 2,3-dichloronaphthoquinone, 1,3-dinitronaphthalene, 1,5-dinitronaphthalene, 9,10-anthraquinone, 1,3,6,8-tetranitrocarbazole, 2,4,7-trinitro-9-fluorenone, 2,3,5,6-tetracyanopyridine, and Fullerene C60 are preferred, hexacyanobutadiene, hexacyanobenzene, tetracyanoethylene, tetracyanoquinodimethane, tetrafluorotetracyanoquinodimethane, p-fluoranyl, p-chloranyl, p-bromanyl, 2,6-dichlorobenzoquinone, 2,5-dichlorobenzoquinone, 2,3-dichloronaphthoquinone, 1,2,4,5-tetracyanobenzene, 2,3-dichloro-5,6-dicyanobenzoquinone, and 2,3,5,6-tetracyanopyridine are more preferred, and tetrafluorotetracyanoquinodimethane is especially preferred.

These electron accepting dopants may be used by one kind alone, or two or more dopants may be used. The amount to be used of the electron accepting dopants differs according to the kind of the material, but the amount is preferably from 0.01 to 50 wt.% on the basis of the material of the hole transporting layer, more preferably from 0.05 to 20 wt.%, and especially preferably from 0.1 to 10 wt.%.

The thickness of the hole-injecting layer and hole transporting layer is each preferably 500 nm or less in view of lowering driving voltage.

The thickness of the hole-transporting layer is preferably from 1 to 500 nm, more preferably from 5 to 200 nm, and still more preferably from 10 to 100 nm. The thickness of the hole-injecting layer is preferably from 0.1 to 200 nm, more preferably from 0.5 to 100 nm, and still more preferably from 1 to 100 nm.

The hole-injecting layer and the hole-transporting layer may have a single layer structure comprising one kind or two or more kinds of the above materials, or may be a multilayer structure comprising a plurality of layers having the same composition or different compositions.

### Electron-Injecting Layer And Electron-Transporting Layer:

The electron-injecting layer and the electron-transporting layer are layers having functions of receiving electrons from the cathode or cathode side and transporting the electrons to the anode side. The electron-injecting material and the electron-transporting material used in these layers may be a low molecular weight material or a high molecular weight material.

Specifically, these layers are preferably layers containing various metal complexes represented by metal complexes of pyridine derivatives, quinoline derivatives, pyrimidine derivatives, pyrazine derivatives, phthalazine derivatives, phenanthroline derivatives, triazine derivatives, triazole derivatives, oxazole derivatives, oxadiazole derivatives, imidazole derivatives, fluorenone derivatives, anthraquinodimethane derivatives, anthrone derivatives, diphenylquinone derivatives, thiopyran dioxide derivatives, carbodiimide derivatives, fluorenylidenemethane derivatives, distyrylpyrazine derivatives, aromatic cyclic tetracarboxylic anhydrides such as naphthalene and perylene, phthalocyanine derivatives, metal complexes of 8-quinolinol derivatives, metal complexes having metalphthalocyanine, benzoxazole or benzothiazole as the ligand, and organic silane derivatives represented by silol. More preferably, these layers are layers containing pyridine derivatives, phenanthroline derivatives, oxazole derivatives, oxadiazole derivatives, imidazole derivatives, or metal complexes of 8-quinolinol derivatives, and still more preferably oxadiazole derivatives or metal complexes of 8-quinolinol derivatives.

When the hydrocarbon compound having an alkyl structure of the invention is contained in the electron-injecting layer and electron-transporting layer, the electron-injecting material and electron-transporting material used together are preferably metal complexes, azole derivatives (benzimidazole derivatives, imidazopyridine derivatives), or azine derivatives (pyridine derivatives, pyrimidine derivatives, triazine derivatives), and in the point of durability, metal complex compounds are preferably used in the invention. As the metal complex compounds, metal complexes having a ligand having at least one nitrogen atom or oxygen atom or sulfur atom coordinating to metals are more preferred.

The electron-injecting layer and the electron-transporting layer of the organic EL device of the invention can contain an electron donating dopant. The electron donating dopants to be introduced to the electron-injecting layer and the electron-transporting layer are sufficient to be electron donating and have a property capable of reducing organic compounds, and alkali metals such as Li, alkaline earth metals such as Mg, transition metals containing rare earth metals, and reductive organic compounds are preferably used. As the metals, metals having a work function of 4.2 eV or less can be preferably used, and specifically Li, Na, K, Be, Mg, Ca, Sr, Ba, Y, Cs, La, Sm, Gd, and Yb are exemplified. As the reductive organic compounds, e.g., nitrogen-containing compounds, sulfur-containing compounds and phosphorus-containing compounds are exemplified.

In addition to the above, materials disclosed in JP-A-6-212153, JP-A-2000-196140, JP-A-2003-68468, JP-A-2003-229278 and JP-A-2004-342614 can be used.

These electron-donating dopants may be used by one kind alone, or two or more kinds of dopants may be used. The amount to be used of the electron-donating dopants differs by the kinds of materials, but the amount is preferably from 0.1 to 99 wt.% on the basis of the electron transporting layer material, more preferably from 1.0 to 80 wt.%, and especially preferably from 2.0 to 70 wt.%.

The thickness of the electron injecting layer and the electron transporting layer is preferably 500 nm or less from the point of lowering the driving voltage.

The thickness of the electron transporting layer is preferably from 1 to 500 nm, more preferably from 5 to 200 nm, and still more preferably from 10 to 100 nm. The thickness of the electron injecting layer is preferably from 0.1 to 200 nm, more preferably from 0.2 to 100 nm, and still more preferably from 0.5 to 50 nm.

The electron injecting layer and the electron transporting layer may have a single layer structure comprising one kind or two or more kinds of the above materials, or may be a multilayer structure comprising a plurality of layers having the same composition or different compositions.

### Hole-Blocking Layer:

The hole-blocking layer is a layer having a function of preventing the holes transported from the anode side to the light-emitting layer from passing through to the cathode side. In the invention, a hole-blocking layer can be provided as an organic layer contiguous to the light-emitting layer on the cathode side.

As the examples of the compounds constituting the hole-blocking layer, aluminum complexes such as aluminum(III)bis(2-methyl-8-quinolinato)-4-phenylphenolate (abbreviation: BAlq), triazole derivatives, and phenanthroline derivatives such as 2,9-dimethyl-4,7-diphenyl-1,10-phenanthroline (abbreviation: BCP) can be exemplified.

The thickness of the hole-blocking layer is preferably from 1 to 500 nm, more preferably from 5 to 200 nm, and still more preferably from 10 to 100 nm.

The hole-blocking layer may have a single layer structure comprising one kind or two or more kinds of the above materials, or may be a multilayer structure comprising a plurality of layers having the same composition or different compositions.

### Electron-Blocking Layer:

The electron-blocking layer is a layer having a function of preventing the electrons transported from the cathode side to the light-emitting layer from passing through to the anode side. In the invention, an electron-blocking layer can be provided as an organic layer contiguous to the light-emitting layer on the anode side.

As the examples of the compounds constituting the electron-blocking layer, for example, the hole-transporting materials described above can be applied.

The thickness of the electron-blocking layer is preferably from 1 to 500 nm, more preferably from 5 to 200 nm, and still more preferably from 10 to 100 nm.

The electron-blocking layer may have a single layer structure comprising one kind or two or more kinds of the above materials, or may be a multilayer structure comprising a plurality of layers having the same composition or different compositions.

### Protective Layer:

In the invention, the organic EL device may be entirely protected with a protective layer.

Protective layers are disclosed, for example, in JP-A-2007-324309, paragraphs [0118] and [0119], and JP-A-2007-266458, paragraphs [0098] to [0099], and the contents therein are applicable to the invention.

### Sealing:

The organic electroluminescence device in the invention may be entirely sealed with a sealing case.

A water-absorbing agent or an inactive liquid may be sealed in the space between the sealing case and the luminescence device. The water-absorbing agent is not especially restricted, and, for example, barium oxide, sodium oxide, potassium oxide, calcium oxide, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieve, zeolite, and magnesium oxide can be exemplified. The inactive liquid is not especially restricted, and, for example, paraffins, liquid paraffins, fluorine solvents, e.g., perfluoroalkane, perfluoroamine, perfluoroether, etc., chlorine solvents, and silicone oils can be exemplified.

A method of sealing with the following shown resin sealing layer is also preferably used.

### Resin Sealing Layer:

It is preferred to restrain deterioration of performance of the device of the invention due to oxygen and moisture by bringing into contact with air by the resin sealing layer.

### Materials:

The materials of the resin sealing layer are not especially restricted, and acrylic resins, epoxy resins, fluorine resins, silicon resins, rubber resins, and ester resins can be used, and epoxy resins are preferred in the point of moisture content-preventing function. Of epoxy resins, thermosetting epoxy resins and photo-curable epoxy resins are preferred.

### Manufacturing Method:

The manufacturing method of the resin sealing layer is not especially restricted and, for example, a method of coating a resin solution, a method of contact bonding or thermal contact bonding of a resin sheet, and a method of dry polymerization by deposition or sputtering are exemplified.

### Film Thickness:

The thickness of the resin sealing layer is preferably 1 µm or more and 1 mm or less, more preferably 5 µm or more and 100 µm or less, and most preferably 10 µm or more and 50 µm or less. When the resin sealing layer is thinner than the above range, there is a possibility that the inorganic film is damaged when a second substrate is applied. While when the resin sealing layer is thicker than the above range, the thickness of the electroluminescence device itself becomes thick and a thin film property of the characteristics of the organic electroluminescence device is impaired.

### Sealing Adhesive:

Sealing adhesive for use in the invention has a function of preventing water and oxygen from getting in from the edge parts.

### Materials:

As the materials of the sealing adhesives, the same materials as the materials used in the resin sealing layer can be used. From the point of waterproofing, epoxy resins are preferred and photo-curable adhesives and thermosetting adhesives are preferred above all.

It is also preferred to add fillers to the above materials.

As the fillers to be added to the sealing agent, inorganic materials such as SiO₂, SiO (silicon oxide), SiON (silicon oxide nitride) and SiN (silicon nitride) are preferred. By the addition of fillers, the viscosity of the sealing agent increases, processing suitability is bettered, and a moisture-proofing property is improved.

### Desiccant:

The sealing adhesive may contain a desiccant. As the desiccant, barium oxide, calcium oxide, and strontium oxide are preferably used.

The addition amount of the desiccant to the sealing adhesive is preferably from 0.01 to 20 wt.%, and more preferably from 0.05 to 15 wt.%. When the addition amount is less than the above range, the effect of the addition of the desiccant decreases, while when the amount is greater than the above range, it is difficult to uniformly disperse the desiccant in the sealing adhesive, so that not preferred.

### Prescription of Sealing Adhesive:

### Polymer composition, concentration

The sealing adhesive is not especially restricted and the above materials can be used. For example, as the photo-curable epoxy adhesive, XNR5516 (manufactured by Nagase Chemtex Corporation) can be exemplified, and it is sufficient that the desiccant is directly added thereto and dispersed.

### Thickness

The coating thickness of the sealing adhesive is preferably from 1 µm to 1 mm. When the coating thickness is thinner than that, the sealing adhesive cannot be coated uniformly and not preferred. When the thickness is greater than that, a way for water to enter widens, so that not preferred.

### Method of Sealing:

In the invention, a functional device can be obtained by coating the sealing adhesive containing the desiccant by means of a dispenser and the like, and superposing a second substrate thereon after coating and hardening.

### Driving:

By the application of D.C. (if necessary, A.C. component may be contained) voltage (generally from 2 to 15 volts) between the anode and the cathode, or by the application of D.C. electric current, light emission of the organic electroluminescence device of the invention can be obtained.

With respect to the driving method of the organic electroluminescence device of the invention, the driving methods disclosed in JP-A-2-148687, JP-A-6-301355, JP-A-5-29080, JP-A-7-134558, JP-A-8-234685, JP-A-8-241047, Japanese Patent 2784615, U.S. Patents 5,828,429 and 6,023,308 can be applied to the invention.

The luminescence device of the invention can be improved in the efficiency of collection of light by various known contrivances. For example, it is possible to improve efficiency of collection of light and improve external quantum efficiency by processing the shape of the substrate surface (for example, by forming a minute rugged pattern), by controlling the refractive indices of the substrate, ITO layer and organic layers, and by controlling the thicknesses of the substrate, ITO layer and organic layers.

The luminescence device of the invention may be what is called top emission system of collecting light from the anode side.

The organic EL device of the invention can take a structure of providing a charge-generating layer between each two layers of a plurality of light-emitting layers for improving luminous efficiency.

The charge-generating layer has functions of generating charge (holes and electrons) at the time of application of electric field and injecting the generated charge to the layer contiguous to the charge-generating layer.

As the material for forming the charge-generating layer, any material can be used so long as it has the above functions, and the charge-generating layer may comprise a single compound or a plurality of compounds.

Specifically, the material may be a material having conductivity, may be a material having semi-conductivity such as a doped organic layer, or may be a material having an electric insulating property, and the materials disclosed in JP-A-11-329748, JP-A-2003-272860 and JP-A-2004-39617 can be exemplified.

More specifically, transparent conductive materials such as ITO and IZO (indium zinc oxide), Fullerenes such as C60, conductive organic materials such as oligothiophene, conductive organic materials such as metallic phthalocyanines, metal-free phthalocyanines, metallic porphyrins, and metal-free porphyrins, metallic materials such as Ca, Ag, Al, Mg-Ag alloy, Al-Li alloy, and Mg-Li alloy, hole-conductive materials, electron-conductive materials, and mixtures of these materials may be used.

As the hole-conductive materials, for example, materials obtained by doping oxidants having an electron-withdrawing property such as F4-TCNQ, TCNQ, FeCl₃ to hole-transporting organic materials such as 2-TNATA and NPD, P-type conductive polymers, and P-type semiconductors are exemplified. As the electron-conductive materials, for example, materials obtained by doping metals or metallic compounds having a work function of less than 4.0 eV to electron-transporting organic materials, N-type conductive polymers, and N-type semiconductors are exemplified. As the N-type semiconductors, N-type Si, N-type CdS, and N-type ZnS are exemplified, and the P-type semiconductors, P-type Si, P-type dTe, and P-type CuO are exemplified.

Further, an electrically insulating material such as V₂O₅ can also be used as the charge-generating layer.

The charge-generating layer may be a monolayer, or a laminate of a plurality of layers. As the structure of lamination of a plurality of layers, a layer having a structure of the lamination of a material having conductivity such as a transparent conductive material or a metallic material and a hole-conductive material or an electron-conductive material, and a layer having a structure of the lamination of the hole-conductive material and the electron-conductive material are exemplified.

The thickness is not especially restricted, but is preferably from 0.5 to 200 nm, more preferably from 1 to 100 nm, still more preferably from 3 to 50 nm, and especially preferably from 5 to 30 nm.

It is preferred to select the thickness and material of the charge-generating layer so that the transmittance of visible light is 50% or more. The forming method of the charge-generating layer is not especially restricted, and the forming method of the organic layers can be used.

The charge-generating layer is formed between each two layers of a plurality of light-emitting layers, and the anode side and the cathode side of the charge generating layer may contain materials having a function of injecting charge to the contiguous layers. For heightening an electron injecting property to the layer contiguous to the anode side, electron injecting compounds such as BaO, SrO, Li₂O, LiCI, LiF, MgF₂, MgO, CaF₂ may be laminated on the anode side of the charge-generating layer.

Besides the above description, the materials of the charge-generating layer can be selected with reference to JP-A-2003-45676, U.S. Patents 6,337,492, 6,107,734 and 6,872,472.

The organic EL device in the invention may have a resonator structure. For example, the organic EL device has a multilayer film mirror comprising a plurality of laminated films different in refractive index, a transparent or translucent electrode, a light-emitting layer, and a metal electrode by superposition on a transparent substrate. The light generated from the light-emitting layer repeats reflection and resonates between the multilayer film mirror and the metal electrode as reflectors.

As another preferred embodiment, a transparent or translucent electrode and a metal electrode respectively function as reflectors on a transparent substrate, and light generated from the light-emitting layer repeats reflection and resonates between them.

To form a resonance structure, effective refractive indices of two reflectors, optical path determined by the refractive index and thickness of each layer between the reflectors are adjusted to be optimal values to obtain a desired resonance wavelength. The expression of the case of the first embodiment is disclosed in JP-A-9-180883. The expression of the case of the second embodiment is disclosed in JP-A-2004-127795.

### Use of the Invention:

The organic electroluminescence device in the invention can be preferably used in display devices, displays, backlights, electrophotography, illumination light sources, recording light sources, exposure light sources, reading light sources, indicators, signboards, interior designs, optical communications, and the like.

As a method of making the organic EL device full colors, for example, as described in Monthly Display, pp. 33-37 (September, 2000), a three-color light-emitting method of arranging organic EL devices emitting lights corresponding to three primary colors (blue (B), green (G) and red (R)) of colors on a substrate, a white color method of separating white color emission by an organic EL device for white color emission to three colors through a color filter, and a color-converting method of converting blue color emission by an organic EL device for blue color emission to red (R) and green (G) through a fluorescent dye layer are known.

Further, by using in combination of a plurality of organic EL devices different in luminescent colors capable of obtaining by the above method, plane light sources of desired luminescent colors can be obtained. For example, a white emission light source of combining luminescence devices of blue and yellow luminescence devices, and a white emission light source of combining luminescence devices of blue, green and red are exemplified.

### EXAMPLES

The invention will be described in further detail with reference to examples, but the invention is by no means restricted thereto.

### Manufacture And Evaluation of Organic Electroluminescence Device:

### (1) Manufacture of organic electroluminescence device in Comparative Example C1-1

A glass substrate having an ITO film of a thickness of 0.5 mm and 2.5 cm square (surface resistance: 10 Ω/□, manufactured by Geomatec Co., Ltd.) is put in a washer and subjected to ultrasonic washing in 2-propanol, and then UV-ozone treatment for 30 minutes. The following organic layers are deposited in order on the transparent anode (ITO film) by vacuum deposition.

The deposition speed in the examples of the invention is 0.2 nm/sec unless otherwise indicated. The deposition speed is measured with a quartz oscillator film formation controller, CRTM-9000 (manufactured by ULVAC, Inc.). The film thickness of each film shown below is also computed from the calibration curves formed from the numeric value of CRTM-9000 and the thickness measured with a Dektak tracer type thickness meter.
<Organic layer 1> Compound A: Film thickness: 160 nm
<Organic layer 2> Compound B: Film thickness: 10 nm
<Organic layer 3> Compound C: Film thickness: 3 nm
<Organic layer 4> Co-deposition of Compound D (85 wt.%) + Light-Emitting Material A (15 wt.%): Film thickness: 60 nm
<Organic layer 5> Compound E: Film thickness: 40 nm

Finally, 0.1 nm of lithium fluoride and metal aluminum are deposited in this order in a thickness of100 nm to prepare a cathode. This is put in a glove box replaced with argon gas so as not to be in contact with the air, and sealed with a stainless steel sealing can and a UV-curing type adhesive (XNR5516HV, manufactured by Nagase Chemtex Corporation) to obtain an organic electroluminescent device Comparative Example C1-1.

The chemical structures of Compound A to Compound E, Compound D', Compound E', Compound D-1 to Compound D-9 used in Examples and Comparative Examples are as shown below.

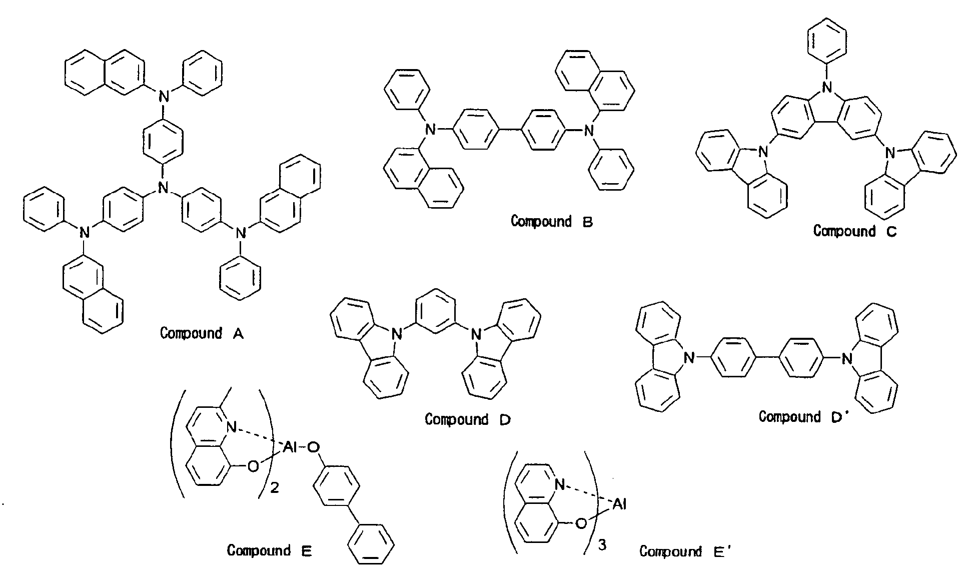

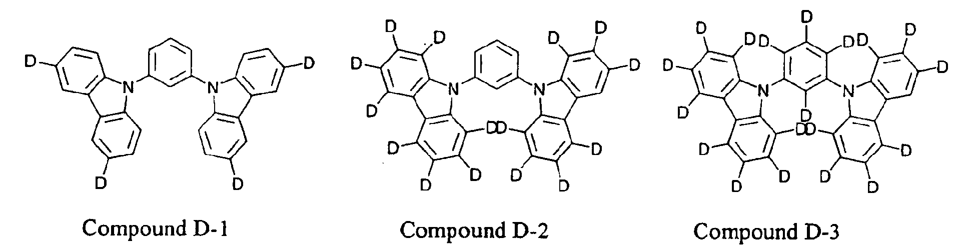

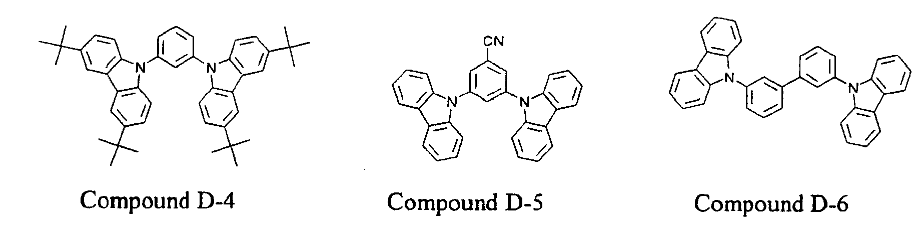

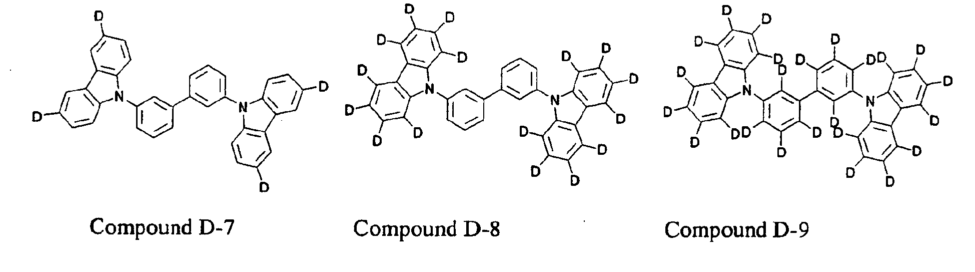

The chemical structures of the light-emitting materials used in Examples and Comparative Examples are as shown below. 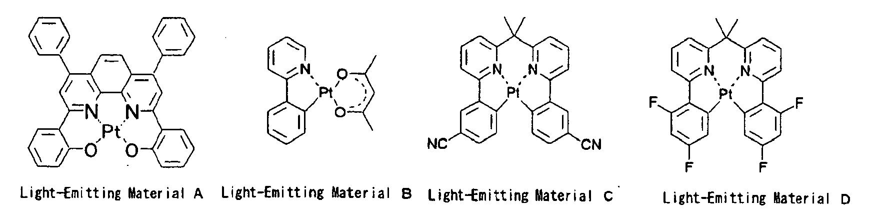 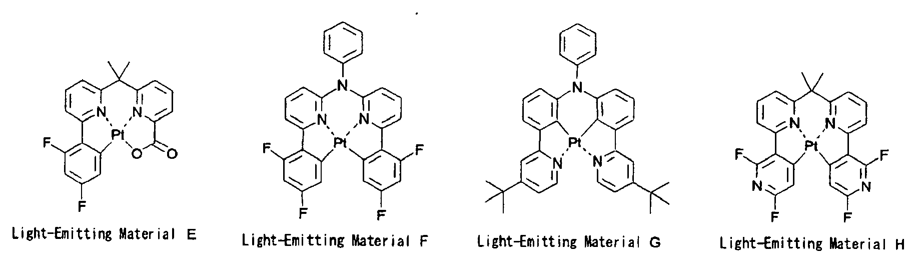 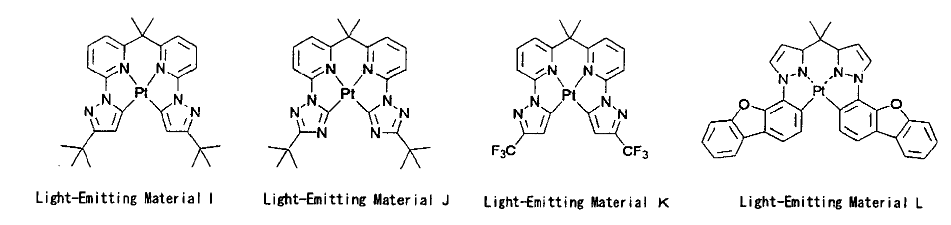 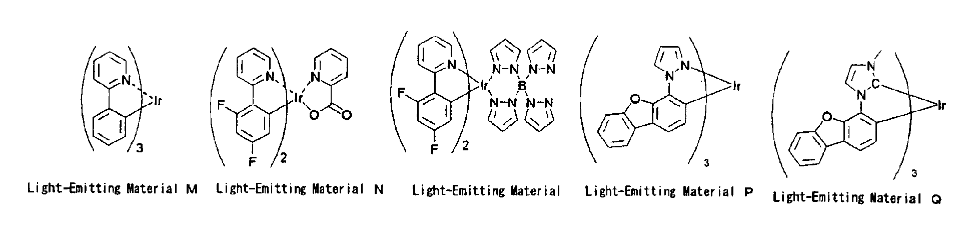 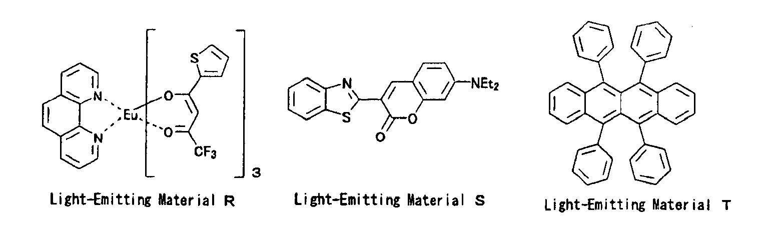 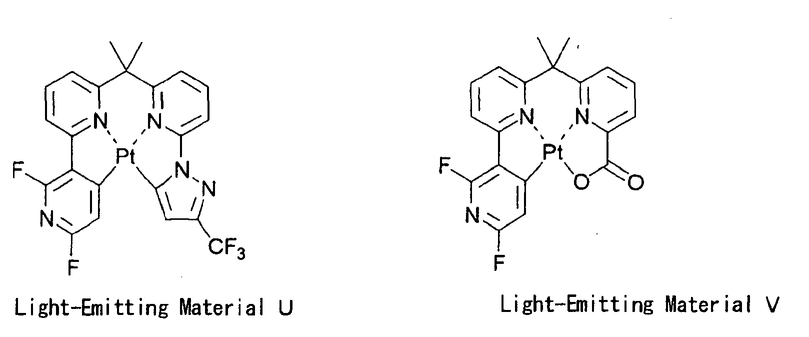 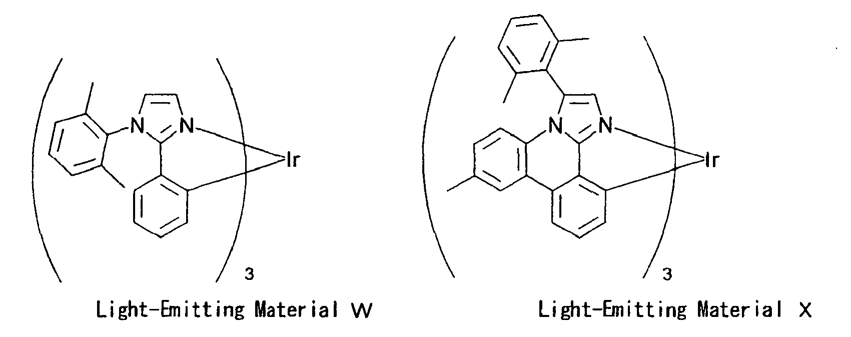 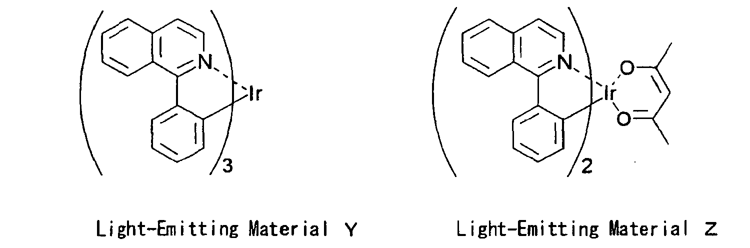 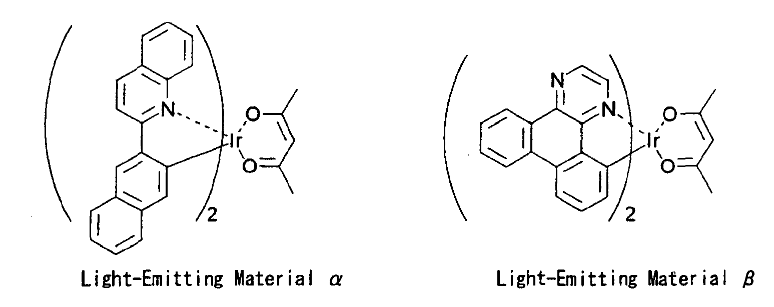 (2) Manufacture of organic electroluminescence devices in Comparative Examples C1-2, C1-3, C1-5, C1-7 to C1-30

The devices in Comparative Examples C1-2, C1-3, C1-5, C1-7 to C1-30 are manufactured in the same structure as in Comparative Example C1-1 except for changing Light-Emitting Material A in <organic layer 4> in Comparative Example C1-1 to Light-Emitting Materials B to Z, α and β shown above according to Table 1 below.

### (3) Manufacture of organic electroluminescence devices in Examples 1-1 to 1-3, 1-5, 1-7 to 1-30

The device in Example 1-1 is manufactured in the same structure as in Comparative Example C1-1 except for changing the part of <organic layer 4> in Comparative Example C1-1 to the following shown <organic layer 4A>.

### <Organic layer 4A> Co-deposition of Compound D (80 wt.%) + Light-Emitting Material A(15 wt.%) + Exemplified Compound 1-2 (5 wt.%): film thickness: 60 nm

The devices in Examples 1-2, 1-3, 1-5, 1-7 to 1-30 are manufactured in the same structure as in Example 1-1 except for changing Light-Emitting Material A in <organic layer 4A> in Example 1-1 to Light-Emitting Materials B to Z, α and β shown above according to Table 1 below.

### (4) Manufacture of organic electroluminescence devices in Comparative Example C1-4 and Example 1-4

The devices in Comparative Example C1-4 and Example 1-4 are manufactured in the same structures as in Comparative Example C1-3 and Example 1-3 respectively except for changing Compound D in Comparative Example C1-3 and

### Example 1-3 to Compound D' shown above.

### (5) Manufacture of organic electroluminescence devices in Comparative Example C1-6 and Example 1-6

The devices in Comparative Example C1-6 and Example 1-6 are manufactured in the same structures as in Comparative Example C1-5 and Example 1-5 respectively except for changing Compound E in Comparative Example C1-5 and Example 1-5 to Compound E' shown above.

The above obtained organic electroluminescence devices are evaluated according to the following methods.

### (6) Evaluation of external quantum efficiency

DC voltage is applied to the obtained organic electroluminescence device for light emission with source measure unit Model 2400 (manufactured by Toyo Corporation). External quantum efficiency is computed from the frontal luminance at the time of 100 cd/m².

### (7) Evaluation of driving durability

Half life time of luminance (the time required for luminance to lower to 50% from the initial luminance) is found by setting the obtained organic electroluminescence device on OLED test system Model ST-D (manufactured by TSK Co.) and driving the device on the condition of normal direction constant current of 0.4 mA by constant current mode.

The results of evaluation of the organic electroluminescence devices of Comparative Examples C1-1 to C1-30 and Examples 1-1 to 1-30 of the invention are shown in Table 1 below (the values of the examples in the invention are shown in relative values with the measured value of corresponding comparative examples being 100). Incidentally, driving voltage is voltage necessary to flow electric current of 0.1 mA to a device.

**Table 1**

| Comparative Example or Example | Light-Emitting Material | Driving Voltage | External Quantum Efficiency | HalfLife Time of Luminance |
|---|---|---|---|---|
| C1-1 | A | 100 | 100 | 100 |
| 1-1 | A | 92 | 112 | 110 |
| C1-2 | B | 100 | 100 | 100 |
| 1-2 | B | 88 | 115 | 110 |
| C1-3 | C | 100 | 100 | 100 |
| 1-3 | C | 83 | 118 | 130 |
| C1-4 | C | 100 | 100 | 100 |
| 1-4 | C | 95 | 110 | 120 |
| C1-5 | D | 100 | 100 | 100 |
| 1-5 | D | 84 | 115 | 138 |
| C1-6 | D | 100 | 100 | 100 |
| 1-6 | D | 86 | 110 | 128 |
| C1-7 | E | 100 | 100 | 100 |
| 1-7 | E | 86 | 114 | 140 |
| C1-8 | F | 100 | 100 | 100 |
| 1-8 | F | 87 | 108 | 125 |
| C1-9 | G | 100 | 100 | 100 |
| 1-9 | G | 90 | 110 | 130 |
| C1-10 | H | 100 | 100 | 100 |
| 1-10 | H | 84 | 117 | 148 |
| C1-11 | I | 00 | 100 | 100 |
| 1-11 | I | 88 | 110 | 128 |
| C1-12 | J | 100 | 100 | 100 |
| 1-12 | J | 89 | 110 | 140 |
| C1-13 | K | 100 | 100 | 100 |
| 1-13 | K | 81 | 118 | 150 |
| C1-14 | L | 100 | 100 | 100 |
| 1-14 | L | 83 | 113 | 132 |
| C1-15 | M | 100 | 100 | 100 |
| 1-15 | M | 94 | 101 | 101 |
| C1-16 | N | 100 | 100 | 100 |
| 1-16 | N | 93 | 105 | 103 |
| C1-17 | O | 100 | 100 | 100 |
| 1-17 | O | 95 | 107 | 110 |
| C1-18 | P | 100 | 100 | 100 |
| 1-18 | P | 96 | 102 | 100 |
| C1-19 | Q | 100 | 100 | 100 |
| 1-19 | Q | 94 | 102 | 103 |
| C1-20 | R | 100 | 100 | 100 |
| 1-20 | R | 94 | 103 | 101 |
| C1-21 | S | 100 | 100 | 100 |
| 1-21 | S | 96 | 105 | 100 |
| C1-22 | T | 100 | 100 | 100 |
| 1-22 | T | 97 | 103 | 100 |
| C1-23 | U | 100 | 100 | 100 |
| 1-23 | U | 82 | 112 | 120 |
| C1-24 | V | 100 | 100 | 100 |
| 1-24 | V | 84 | 115 | 116 |
| C1-25 | W | 100 | 100 | 100 |
| 1-25 | W | 95 | 110 | 104 |
| C1-26 | X | 100 | 100 | 100 |
| 1-26 | X | 92 | 105 | 106 |
| C1-27 | Y | 100 | 100 | 100 |
| 1-27 | Y | 94 | 108 | 103 |
| C1-28 | Z | 100 | 100 | 100 |
| 1-28 | Z | 97 | 102 | 102 |
| C1-29 | α | 100 | 100 | 100 |
| 1-29 | α | 91 | 108 | 104 |
| C1-30 | β | 100 | 100 | 100 |
| 1-30 | β | 96 | 109 | 101 |

From the results in Table 1, it has been shown that in the organic electroluminescence devices in the invention, addition of the hydrocarbon compound having an alkyl structure has the effects of reducing driving voltage, improving external quantum efficiency and bettering half life time of luminance.

### (8) Measurement of mobility of holes

Compound D is deposited on a glass plate having ITO in a thickness of about 2 µm and aluminum is deposited thereon to prepare a sample. Mobility of holes found with the sample by time of flight (TOF) method is 4.06 × 10⁻⁴ cm²·^{V-}1·s⁻¹ (electric field is 1 × 10⁶ V·cm⁻¹). Regarding TOF method, Synth. Met., 111/112, page 331 (2000) can be referred to.

Further, mobility of holes found by TOF method with a sample obtained by depositing Compound D and Exemplified Compound (1-2) in a ratio of 95/5 (by wt.%) on a glass plate having ITO in a thickness of about 2 µm and depositing aluminum thereon is 1.05 × 10⁻³ cm²·V⁻¹·s⁻¹ (electric field is 1 × 10⁶ V·cm⁻¹). The mobility of holes is about 2.5 times higher as compared with the case where Exemplified Compound (1-2) is not added. This result shows that driving voltage of organic electroluminescence devices can be reduced by the addition of a material containing an alkane structure of the invention.

The invention can provide an organic electroluminescence device low in driving voltage, and excellent in EL external quantum efficiency and durability.

## Claims

1. An organic electroluminescence device comprising:
a pair of electrodes; and
at least one organic layer including a light-emitting layer being provided between the pair of electrodes,
wherein
at least any one of the at least one organic layer contains both at least one hydrocarbon compound having an alkyl structure and a charge transporting material, and
**characterized in that** the hydrocarbon compound having an alkyl structure is a saturated straight chain hydrocarbon compound not containing a double bond and containing a -CH₂CH₂-structure.

2. The organic electroluminescence device as claimed in claim 1, wherein
the hydrocarbon compound having an alkyl structure is solid at room temperature.

3. The organic electroluminescence device as claimed in claim 1 or 2, wherein
the hydrocarbon compound having an alkyl structure is contained in the organic layer in an amount of from 0.1 to 25 wt.%.

4. The organic electroluminescence device as claimed in any of claims 1 to 3, wherein
the light-emitting layer contains the hydrocarbon compound having an alkyl structure.

5. The organic electroluminescence device as claimed in any of claims 1 to 4, wherein
the light-emitting layer contains at least one phosphorescent material.

6. The organic electroluminescence device as claimed in any of claims I to 5, wherein
the charge transporting material is a hole-transporting material.

7. The organic electroluminescence device as claimed in any of claims 1 to 6, wherein
the light-emitting layer contains a metal complex phosphorescent material.

8. The organic electroluminescence device as claimed in any of claims I to 7, wherein
the light-emitting layer contains an iridium complex material or a platinum complex material.

9. The organic electroluminescence device as claimed in any of claims 1 to 8, wherein
the light-emitting layer contains a platinum complex material having a tetradentate ligand.

## Patentansprüche

1. Organische Elektrolumineszenzvorrichtung, umfassend:
ein Paar Elektroden; und
mindestens eine organische Schicht, die eine lichtemittierende Schicht umfasst, welche zwischen dem Paar Elektroden vorgesehen ist,
worin mindestens irgendeine von der mindestens einen organischen Schicht beides von mindestens einer Kohlenwasserstoffverbindung mit einer Alkylstruktur und einem ladungstransportierenden Material enthält, und die **dadurch gekennzeichnet ist, dass** die Kohlenwasserstoffverbindung mit einer Alkylstruktur eine gesättigte, geradkettige Kohlenwasserstoffverbindung ist, die keine Doppelbindung enthält und eine -CH₂CH₂-Struktur enthält.

2. Organische Elektrolumineszenzvorrichtung gemäß Anspruch 1, worin die Kohlenwasserstoffverbindung mit einer Alkylstruktur bei Raumtemperatur fest ist.

3. Organische Elektrolumineszenzvorrichtung gemäß Anspruch 1 oder 2, worin die Kohlenwasserstoffverbindung mit einer Alkylstruktur in der organischen Schicht in einer Menge von 0,1 bis 25 Gew.% enthalten ist.

4. Organische Elektrolumineszenzvorrichtung gemäß irgendeinem der Ansprüche 1 bis 3, worin die lichtemittierende Schicht die Kohlenwasserstoffverbindung mit einer Alkylstruktur enthält.

5. Organische Elektrolumineszenzvorrichtung gemäß irgendeinem der Ansprüche 1 bis 4, worin die lichtemittierende Schicht mindestens ein phosphoreszierendes Material enthält.

6. Organische Elektrolumineszenzvorrichtung gemäß irgendeinem der Ansprüche 1 bis 5, worin das ladungstransportierende Material ein Lochtransportierendes Material ist.

7. Organische Elektrolumineszenzvorrichtung gemäß irgendeinem der Ansprüche 1 bis 6, worin die lichtemittierende Schicht ein phosphoreszierendes Metallkomplex-Material enthält.

8. Organische Elektrolumineszenzvorrichtung gemäß irgendeinem der Ansprüche 1 bis 7, worin die lichtemittierende Schicht ein Iridium-Komplexmaterial oder ein Platin-Komplexmaterial enthält.

9. Organische Elektrolumineszenzvorrichtung gemäß irgendeinem der Ansprüche 1 bis 8, worin die lichtemittierende Schicht ein Platin-Komplexmaterial enthält, das einen vierzähnigen Liganden aufweist.

## Revendications

1. Dispositif électroluminescent organique comprenant :
une paire d'électrodes ; et
au moins une couche organique comprenant une couche électroluminescente se trouvant entre la paire d'électrodes,
dans lequel
au moins l'une quelconque de l'au moins une couche organique contient à la fois au moins un composé hydrocarboné possédant une structure d'alkyle et une substance de transport de charges, et
**caractérisé en ce que** le composé hydrocarboné possédant une structure d'alkyle est un composé hydrocarboné saturé à chaîne linéaire ne contenant pas de double liaison et contenant une structure -CH₂CH₂-.

2. Dispositif électroluminescent organique selon la revendication 1, dans lequel
le composé hydrocarboné possédant une structure d'alkyle est solide à température ambiante.

3. Dispositif électroluminescent organique selon la revendication 1 ou 2, dans lequel
le composé hydrocarboné possédant une structure d'alkyle est contenu dans la couche organique en une quantité de 0,1 % à 25 % en poids.

4. Dispositif électroluminescent organique selon l'une quelconque des revendications 1 à 3, dans lequel
la couche électroluminescente contient le composé hydrocarboné possédant une structure d'alkyle.

5. Dispositif électroluminescent organique selon l'une quelconque des revendications 1 à 4, dans lequel
la couche électroluminescente contient au moins une substance phosphorescente.

6. Dispositif électroluminescent organique selon l'une quelconque des revendications 1 à 5, dans lequel
la substance de transport de charges est une substance de transport de trous.

7. Dispositif électroluminescent organique selon l'une quelconque des revendications 1 à 6, dans lequel
la couche électroluminescente contient une substance phosphorescente de type complexe métallique.

8. Dispositif électroluminescent organique selon l'une quelconque des revendications 1 à 7, dans lequel
la couche électroluminescente contient une substance de type complexe d'iridium ou une substance de type complexe de palladium.

9. Dispositif électroluminescent organique selon l'une quelconque des revendications 1 à 8, dans lequel
la couche électroluminescente contient une substance de type complexe de palladium contenant un ligand tétradentate.
